# EUROPEAN PATENT APPLICATION

(11) **EP 1 768 173 A1**
(43) Date of publication of application: **28.03.2007**
(21) Application number: 05745964.6
(22) Date of filing: 31.05.2005
(51) Int. Cl.: H01L 21/66

(54) **METHOD FOR EVALUATING SOI WAFER**

(30) Priority: 25.06.2004 JP 2004187435; 25.06.2004 JP 2004187437; 25.06.2004 JP 2004187440; 25.06.2004 JP 2004187460
(71) Applicant: SHIN-ETSU HANDOTAI COMPANY LIMITED, Chiyoda-ku Tokyo 100-0005 (JP)
(72) Inventor: OHTSUKI, Tsuyoshi c/o Isobe R & D Center, Annaka-shi, Gunma 3790196 (JP); SATO, Hideki c/o Isobe R & D Center, Annaka-shi, Gunma 3790196 (JP)
(74) Representative: Wibbelmann, Jobst
(86) International application number: PCT/JP2005/009922
(87) International publication number: WO 2006/001156

(57) **Abstract**

The present invention is a method for evaluating an SOI wafer by using a mercury probe, comprising at least steps of, subjecting the SOI wafer to a hydrofluoric acid cleaning treatment and thereby to remove a native oxide film formed in a surface of the SOI wafer, next subjecting the native oxide film-removed SOI wafer to a treatment for stabilizing charge state, then contacting the charge-state stabilizing-treated SOI wafer with the mercury probe, and thereby evaluating the SOI wafer. Thereby, there can be provided an evaluation method in which a large-scale apparatus and multiple steps such as a photolithography process are not required and by which an electric characteristic of an SOI wafer can be measured simply and high-precisely in a short time and operation rate of measurement apparatus is improved and thereby the SOI wafer can be effectively evaluated.

## Description

### Technical Field

The present invention relates to a method for evaluating an SOI wafer by which an SOI layer of the SOI wafer and an interface between the SOI layer and a buried oxide layer are evaluated by using a mercury probe.

### Background Art

In recent years, an SOI wafer having an SOI structure in which an SOI layer (also referred to as a silicon active layer) is formed on an oxide film with an electrically insulating property is excellent in high-speed property, low consumption electric power property, high breakdown voltage property, environment resistance, and so forth, of devices, and therefore, has particularly attracted attention as a high-performance LSI wafer for an electronic device. This is because in a SOI wafer, a buried oxide film (hereinafter, occasionally referred to as a BOX layer), which is an insulator, exists between a support substrate and the SOI layer, and therefore, an electronic device formed on an SOI layer has high voltage endurance and also a large advantage that soft error rate of α-ray lowers.

Moreover, with respect to a thin-film SOI wafer with the SOI layer having a thickness of 1 µm or less, in the case that a MOS (Metal Oxide Semiconductor) type semiconductor device formed on the SOI layer is operated as a complete depletion type, PN junction area of source/drain can be small, and therefore, parasitic capacity is reduced and speeding up of device driving can be planned. Furthermore, because capacity of a BOX layer to be an insulator layer becomes in series with capacity of a depletion layer formed immediately below a gate oxide film, the capacity of a depletion layer is substantially reduced and lowering of consumption electric power can be realized.

Recently, because electronic devices have become further finer and have had higher performance, an SOI wafer of higher quality has been demanded. Therefore, evaluation of quality of an SOI layer and such of an SOI wafer has been positively performed. As one method for evaluating the quality of an SOI wafer, it has been performed that a MOS structure is formed on a surface of the SOI layer and voltage is applied to electrode parts thereof and the quality of the SOI layer is evaluated.

However, in the case of forming a MOS structure on an SOI layer for evaluating an SOI wafer, a large-scale apparatus and multiple steps are required for performing a photolithography process and such, and there have been troubles such as large burden to cost and lack of rapidity. Moreover, by this method, quality of an SOI layer surface can be evaluated, and however, evaluation of an interface between the SOI layer and a BOX layer has been incomplete.

Accordingly, there has been developed an evaluation method by which an SOI wafer can be evaluated more simply by using a mercury probe without forming a MOS structure on an SOI wafer through multiple steps as a conventional method. As one method thereof, Pseudo MOS FET method in which an object of the evaluation is an SOI wafer has been suggested (see, for example, Japanese Patent Application Laid-open (kokai) No. 2001-60676, Japanese Patent Application Laid-open (kokai) No. 2001-267384, and S. Cristoleveanu et al., "A Review of the Pseudo-MOS Transistor in SOI Wafers: Operation, Parameter Extraction, and Applications" IEEE Trans. Electron Dev, 47 1018 (2000)(Document No. 1), H. J. Hovel, "Si film electrical characterization in SOI substrates by HgFET technique" Solid-State Electronics, 47, 1311 (2003) (Document No. 2)). According to this method, an interface state density in the interface between an SOI layer and a BOX layer, an electric characteristic of the SOI layer, or the like, can be good-precisely measured simply.

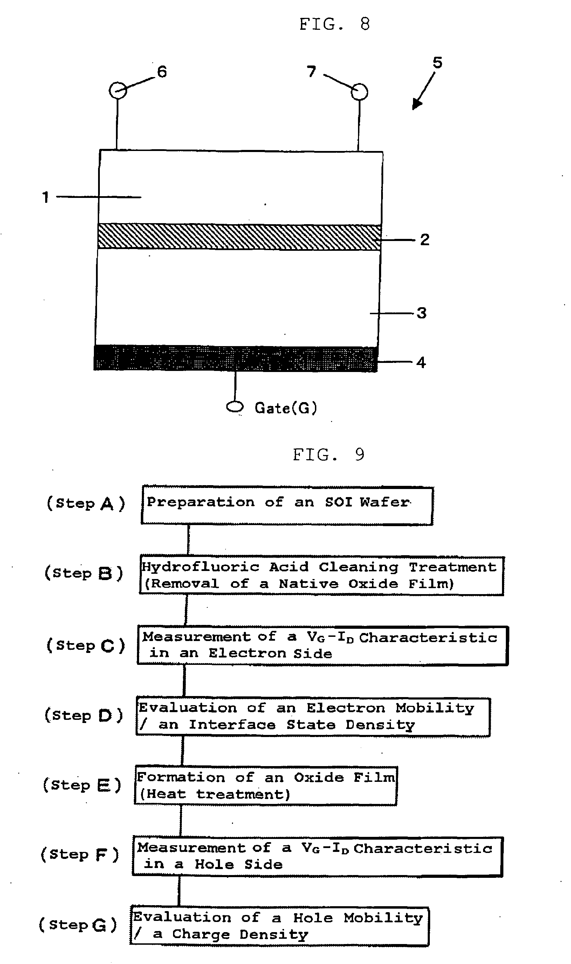

Here, Pseudo MOS FET method is explained simply with reference to a drawing. First, as shown in Fig. 8, on the side of an SOI layer 1 of an SOI wafer 5 in which a pseudo MOS structure is formed with a BOX layer 2 being a gate oxide film, needle probes or mercury probes are directly contacted as electrodes for evaluation and they are set to be a source electrode 6 and a drain electrode 7. A back surface of the SOI wafer 5, namely, a surface in the side of a support wafer 3 of the SOI wafer 5 is vacuum-contacted on a stage that is also used as an electrode and thereby a gate electrode 4 is formed. Various electric characteristics can be obtained by applying voltage between these electrodes. In this case, the above-described gate electrode 4 can be also formed, for example, by contacting a needle on the back surface of the SOI wafer 5.

Moreover, in the evaluation of an SOI wafer by Pseudo MOS FET method, by cleaning the SOI wafer with an aqueous solution containing hydrofluoric acid before the evaluation, a native oxide film formed on the SOI layer surface can be removed, and therefore, by excluding effect of the native oxide film, it becomes possible to evaluate more accurate electric characteristics of an SOI wafer.

Furthermore, in the Pseudo MOS FET method, if mercury probes are used as a source electrode and a drain electrode, a probe contact hole to be generated in contacting a needle probe on the SOI layer surface is not formed, and therefore, repeat measurements and a measurement in the vicinity of a first measured point can be performed simply and stably.

After forming a Pseudo MOS structure as described above, gate voltage is applied in the positive side in a state of applying drain voltage and thereby the relation of gate voltage V_{G} and drain current I_{D}, namely, a V_{G}-I_{D} characteristic is measured, and thereby an electron mobility of the SOI layer and an interface state density in the interface between the SOI layer and the BOX layer can be evaluated. On the other hand, by measuring a V_{G}-I_{D} characteristic by applying gate voltage in the negative side in a state of applying drain voltage, a hole mobility of the SOI layer and a charge density of the BOX layer can be evaluated.

By the way, in the case of evaluating an SOI wafer by applying gate voltage in the negative side as described above, conventionally even when the measurement of a V_{G}-I_{D} characteristic is initiated immediately after the native oxide film on the SOI layer surface is removed by cleaning the SOI wafer with an aqueous solution containing hydrofluoric acid, the measurement value is not stable without 10-12 hr or more passing, and therefore, the V_{G}-I_{D} characteristic cannot be accurately measured. Therefore, there have been problems that a very long evaluation time is required for evaluating an SOI wafer and that operation rate of the measurement apparatus is lowered and that efficiency improvement of the SOI wafer evaluation is prevented.

Moreover, in the above case, there has been a problem that administrative burden is large because the SOI wafer has to be precisely administered so that impurities do not adhere to the wafer after the removal of the native oxide film until accomplishment of the measurement.

### Disclosure of the Invention

Accordingly, the present invention was conceived in view of the above problems. An object of the present invention is to provide an evaluation method in which a large-scale apparatus and multiple steps such as a photolithography process are not required and by which an electric characteristic of an SOI wafer can be measured simply and high-precisely in a short time and operation rate of measurement apparatus is improved and thereby the SOI wafer can be effectively evaluated.

In order to accomplish the above object, according to the present invention, there is provided a method for evaluating an SOI wafer by using a mercury probe, comprising at least steps of, subjecting the SOI wafer to a hydrofluoric acid cleaning treatment and thereby to remove a native oxide film formed in a surface of the SOI wafer, next subjecting the native oxide film-removed SOI wafer to a treatment for stabilizing charge state, then contacting the charge-state stabilizing-treated SOI wafer with the mercury probe, and thereby evaluating the SOI wafer.

By subjecting the SOI wafer to a treatment for stabilizing charge state after a native oxide film formed on the SOI wafer is removed by a hydrofluoric acid cleaning treatment as described above, charge state on the SOI layer surface can be rapidly stabilized to be a steady state. Thereby, a time required from the removal of the native oxide film to the measurement of an electric characteristic of the SOI wafer can be drastically shortened compared to that of a conventional method, and the evaluation of an SOI wafer can be performed in a very short time and improvement of operation rate of measurement apparatus can be planned. Moreover, in the present invention, the charge state on the SOI layer surface can be effectively stabilized in a short time before an electric characteristic of the SOI wafer is measured, and therefore, administration of the SOI wafer becomes easy, and furthermore dispersion of measurement value can be reduced and highly reliable evaluation of an SOI wafer can be stably performed.

In the above case, it is preferable that the treatment for stabilizing charge state is performed by loading a charge on an SOI layer surface of the SOI wafer by performing a corona discharge treatment or performed by forming an oxide film on an SOI layer surface of the SOI wafer.

As described above, the treatment for stabilizing charge state can be performed by loading a charge on an SOI layer surface of the SOI wafer by performing a corona discharge treatment or performed by forming newly a silicon oxide film having an equivalent film-thickness on an SOI layer surface of the SOI wafer.

Moreover, it is preferable that the charge loaded on a SOI layer surface of the SOI wafer by a corona discharge treatment is a positive charge.

When the charge loaded on the SOI layer surface by a corona discharge treatment is a positive charge, for example, a hydrogen ion such as H⁺ can be used as a gas carrying a charge exposing the wafer surface. In the corona discharge treatment, when the hydrogen ion is emitted from a corona charge electrode, moisture (H₂O) in the air gathers around the hydrogen ion to form a form of (H₂O)ₙH⁺ and thereby it is loaded on the SOI layer surface as a positive charge. Because large amount of the moisture binding to hydrogen ions exists in the air, it is not necessary that a special chamber bothers to be used for performing a corona discharge treatment, and therefore, a charge can be more simply loaded on the SOI layer surface.

Moreover, it is preferable that amount of the charge loaded on the SOI layer surface by a corona discharge treatment is 500 nC/cm² to 50000 nC/cm².

When amount of the charge loaded on the SOI layer surface by a corona discharge treatment is 500 nC/cm² to 50000 nC/cm², the charge state on the SOI layer surface subjected to a hydrofluoric acid cleaning treatment can be very effectively stabilized in a short time.

Moreover, it is preferable that thickness of the oxide film formed on the SOI layer surface is 5 nm or less.

When thickness of the oxide film formed on the SOI layer surface is very thin, 5 nm or less, electricity can be certainly passed through the oxide film by tunnel effect of the silicon oxide film having a thin film-thickness in evaluating the SOI wafer by contacting the mercury probe after formation of the oxide film. Therefore, an electric characteristic of an SOI wafer can be measured accurately.

Moreover, it is preferable that the formation of an oxide film on the SOI layer surface is performed by subjecting the SOI wafer to a heat treatment, an ultraviolet irradiation treatment, or a second cleaning treatment by using a cleaning solution being capable of forming a silicon oxide film.

When the formation of an oxide film on the SOI layer surface is performed by subjecting the SOI wafer to a heat treatment, an ultraviolet irradiation treatment, or a second cleaning treatment by using a cleaning solution being capable of forming a silicon oxide film, thickness of the oxide film to be formed can be controlled easily and high-precisely, and thereby an oxide film having a desired film-thickness can be stably formed uniformly on the SOI layer surface.

Moreover, it is preferable that the heat treatment of the SOI wafer or the ultraviolet irradiation treatment thereof is performed in an atmosphere containing oxygen, and particularly, it is preferable that the atmosphere containing oxygen is an air or a 100% oxygen atmosphere.

When the heat treatment of the SOI wafer is performed in an atmosphere containing oxygen, an oxide film having a uniform film-thickness can be formed easily and stably. Moreover, when the ultraviolet irradiation treatment of the SOI wafer is performed in an atmosphere containing oxygen, ozone is generated from the oxygen contained in the atmosphere, and excited oxygen atoms are decomposed from the ozone and react with silicons on the SOI layer surface, and thereby an oxide film having a uniform film-thickness can be formed very easily and stably on the SOI layer surface. In particular, when the atmosphere containing oxygen is an air, a special atmospheric gas is not required to be prepared in performing the heat treatment or the ultraviolet irradiation treatment, and the heat treatment or the ultraviolet irradiation treatment can be performed by using a simple apparatus, and therefore, the formation of the oxide film can be performed extremely easily. Moreover, when the atmosphere containing oxygen is a 100% oxygen atmosphere, the formation of a uniform oxide film proceeds rapidly even at a relatively low temperature in the case of performing the heat treatment, and therefore, the heat treatment time can be shortened in itself, and also temperature lowering of the heat treatment temperature can be planned. Moreover, when the atmosphere containing oxygen is a 100% oxygen atmosphere, the formation of a uniform oxide film proceeds rapidly by promoting generation of ozone in the case of performing the ultraviolet irradiation treatment, and therefore, the treatment time can be shortened.

Moreover, it is preferable that the heat treatment of the SOI wafer is performed at temperature of 50°C to 350°C.

When the heat treatment of the SOI wafer is performed at temperature of 50°C to 350°C, a silicon oxygen film can be stably grown on the SOI layer surface, and an oxide film having a desired thickness and a uniform film-thickness in the wafer plane can be easily formed, and therefore, more accurate evaluation of an SOI wafer can be stably performed.

Moreover, it is preferable that the cleaning solution being capable of forming a silicon oxide film is selected from, ozone water, aqueous solution containing ammonium and hydrogen peroxide solution, hydrogen peroxide solution, aqueous solution containing hydrochloric acid and hydrogen peroxide solution, aqueous solution containing sulfuric acid and hydrogen peroxide solution, and highly oxidizing aqueous solution having high oxidation-reduction potential, and particularly it is preferable that the highly oxidizing aqueous solution is electrolyzed anode water.

In an aqueous solution as presented above, a component being capable of forming rapidly a silicon oxide film on the SOI layer surface such as OH⁻ ion contained in a highly oxidizing aqueous solution such as ozone or hydrogen peroxide or electrolyzed anode water is contained, and therefore by subjecting the SOI wafer to the second cleaning treatment by using an aqueous solution selected from the above, an oxide film having a uniform film-thickness can be very stably formed on the SOI layer surface.

Moreover, it is preferable that when the second cleaning treatment is performed, liquid temperature of the cleaning solution being capable of forming a silicon oxide film is room temperature to 80°C.

When the second cleaning treatment is performed by using the cleaning solution of which liquid temperature is in the above temperature range, OH- ion contained in ozone or hydrogen peroxide or electrolyzed anode water or the like can be reacted rapidly with silicon on the SOI layer surface, and thereby an oxygen film having an uniform film-thickness can be formed simply and certainly.

Moreover, in the present invention, it is preferable that a V_{G}-I_{D} characteristic in a hole side therein is measured by contacting the charge-state stabilizing-treated SOI wafer with the mercury probe and thereby a hole mobility of an SOI layer in the SOI wafer and/or a charge density of a buried oxide film therein are/is evaluated.

As described above, in the present invention, after the native oxide film is removed by the hydrofluoric acid cleaning treatment, charge state on the SOI layer surface can be stabilized in a short time by the treatment for stabilizing charge state, and therefore by then measuring a V_{G}-I_{D} characteristic in a hole side by contacting the SOI wafer with the mercury probe, dispersion of measurement value can be significantly reduced. Therefore, a hole mobility of an SOI layer and an electric density of a buried oxide film which easily cause dispersion in measurement value and require a long time to the accurate measurement in a conventional method can be evaluated high-precisely in a short time with high reliability.

Furthermore, in the present invention, it is preferable that after removing a native oxide film by performing the hydrofluoric acid cleaning treatment, a V_{G}-I_{D} characteristic in an electron side therein is measured by contacting the native oxide film-removed SOI wafer with the mercury probe and thereby an electron mobility of the SOI layer and/or an interface state density between the SOI layer and the buried oxide film are/is evaluated, and then the treatment for stabilizing charge state is performed.

After the removal of a native oxide film by the hydrofluoric acid cleaning treatment, a V_{G}-I_{D} characteristic in an electron side therein is measured by contacting the SOI wafer with the mercury probe before performing the treatment for stabilizing charge state as described above, and thereby, the electron mobility or the interface state density can be evaluated high-precisely, and it becomes possible that quality of the SOI wafer can be evaluated in more detail.

Moreover, it is preferable that after performing the hydrofluoric acid cleaning treatment, a negative charge is loaded on the SOI layer surface by subjecting the SOI wafer to the corona discharge treatment before measuring the V_{G}-I_{D} characteristic in an electron side therein by contacting the SOI wafer with the mercury probe.

By loading a negative charge on the SOI layer surface by subjecting the SOI wafer to the corona discharge treatment after the hydrofluoric acid cleaning treatment as described above, charge state on the SOI layer surface can be stabilized in a short time before measuring the V_{G}-I_{D} characteristic in an electron side therein. Therefore, the measurement of the V_{G}-I_{D} characteristic in an electron side therein can be performed stably without causing dispersion in measurement value, and thereby the evaluation of an electron mobility or an interface state density can be performed more high-precisely.

As described above, according to the present invention, in evaluating an SOI wafer, after removing a native oxide film of the SOI wafer by a hydrofluoric acid cleaning treatment, the SOI wafer subjected to a treatment for stabilizing charge state in which a charge is loaded on the SOI layer surface by performing a corona discharge treatment, or in which a silicon oxide film is newly formed, or the like, and thereby charge state on the SOI layer surface can be rapidly stabilized to be a steady state. Thereby, a time required from the removal of the native oxide film to the measurement of an electric characteristic of the SOI wafer can be drastically shortened as compared to that of a conventional method, and the evaluation of an SOI wafer can be performed in a very short time, and also improvement of operation rate of measurement apparatus can be planned. Moreover, in the present invention, the time from the removal of the native oxide film to the measurement of an electric characteristic of the SOI wafer can be drastically shortened, and therefore administration of the SOI wafer becomes easy, and furthermore, charge state on the SOI layer surface is stable in measuring a V_{G}-I_{D} characteristic, and therefore, dispersion of measurement value is reduced, and highly reliable evaluation of an SOI wafer can be stably performed high-precisely.

### Brief Explanation of the Drawings

Fig. 1 is a flow chart showing an example of the method for evaluating an SOI wafer according to the present invention.
Fig. 2 is a schematic constitution view showing an example of a corona charge apparatus for performing a corona discharge treatment.
Fig. 3 is a schematic constitution view of a mercury probe apparatus.
Fig. 4 is an electrode plane view of a mercury electrode in the mercury probe apparatus.
Fig. 5 is a graph showing an example of a V_{G}-I_{D} characteristic in a hole side that is measured in the method for evaluating an SOI wafer of the present invention.
Fig. 6 is a graph showing an example of a V_{G}-I_{D} characteristic in an electron side that is measured in the method for evaluating an SOI wafer of the present invention.
Fig. 7 is a graph showing a relation between amount of a charge loaded on an SOI layer surface by a corona discharge treatment and drain current measured by forming a Pseudo-MOS structure.
Fig. 8 is a type view typically representing Pseudo MOS FET method.
Fig. 9 is a flow chart showing another example of the method for evaluating an SOI wafer of the present invention.
Fig. 10 is a flow chart showing further another example of the method for evaluating an SOI wafer of the present invention.
Fig. 11 is a schematic constitution view schematically showing a constitution of a hot plate.
Fig. 12 is a flow chart showing further another example of the method for evaluating an SOI wafer of the present invention.
Fig. 13 is a flow chart showing further another example of the method for evaluating an SOI wafer of the present invention.
Fig. 14 is a schematic constitution view schematically showing a constitution of an ultraviolet treatment apparatus.
Fig. 15 is a flow chart showing further another example of the method for evaluating an SOI wafer of the present invention.
Fig. 16 is a flow chart showing further another example of the method for evaluating an SOI wafer of the present invention.
Fig. 17 is a graph showing a V_{G}-I_{D} characteristic in an electron side measured in Example 1.
Fig. 18 is a graph showing a V_{G}-I_{D} characteristic in a hole side measured in Example 1.
Fig. 19 is a graph showing a V_{G}-I_{D} characteristic in an electron side measured in Examples 2-10.
Fig. 20 is a graph showing a V_{G}-I_{D} characteristic in a hole side measured in Example 2.
Fig. 21 is a graph showing a V_{G}-I_{D} characteristic in a hole side measured in Example 3.
Fig. 22 is a graph showing a V_{G}-I_{D} characteristic in a hole side measured in Examples 4-10.
Fig. 23 is a graph showing a V_{G}-I_{D} characteristic in a hole side measured in Comparative example 1.
Fig. 24 is a graph showing a V_{G}-I_{D} characteristic in a hole side measured in Comparative example 2.

### Best Mode for Carrying out the Invention

Hereinafter, embodiments according to the present invention will be explained. However, the present invention is not limited thereto.

Conventionally, in the case of evaluating a hole mobility of an SOI layer and a BOX layer charge density and so forth in an SOI wafer by Pseudo MOS FET method, measurement value is not stable without 10 hr or more passing after removing a native oxide film on the SOI layer surface by cleaning the SOI wafer with an aqueous solution containing hydrofluoric acid, and therefore there has been a problem that a very long time is required for evaluation of an SOI wafer.

This has been thought to be because in the case of measuring a V_{G}-I_{D} characteristic by applying gate voltage in the negative side such as the evaluation of a hole mobility or a BOX layer charge density, unless the surface state is controlled by adsorbing a positive charge such as H⁺ ion on the SOI layer surface, a charge in the SOI layer surface is not stable and accurate measurement is impossible. That is, it is thought that without 10 hr or more passing after removing the native oxide film on the SOI layer surface by hydrofluoric acid cleaning, electric state on the SOI layer surface has not been stable, and therefore measurement thereof has been impossible.

Accordingly, the present inventors have thought that in evaluating an SOI wafer by using a mercury probe, by performing a treatment for stabilizing charge state on the SOI layer surface after removing the native oxide film, a time required for the evaluation of an SOI wafer can be shortened, and they have experimented and studied thoroughly. As a result, they had found that after subjecting an SOI wafer to hydrofluoric acid cleaning, the SOI wafer subjected to a treatment for stabilizing charge state in which a charge is loaded on the SOI layer surface by performing a corona discharge treatment, or in which a silicon oxide film is newly formed, or the like, and then the SOI wafer is evaluated by using the mercury probe, and thereby the evaluation of an SOI wafer can be performed high-precisely in a short time. Thereby, the present invention has been accomplished.

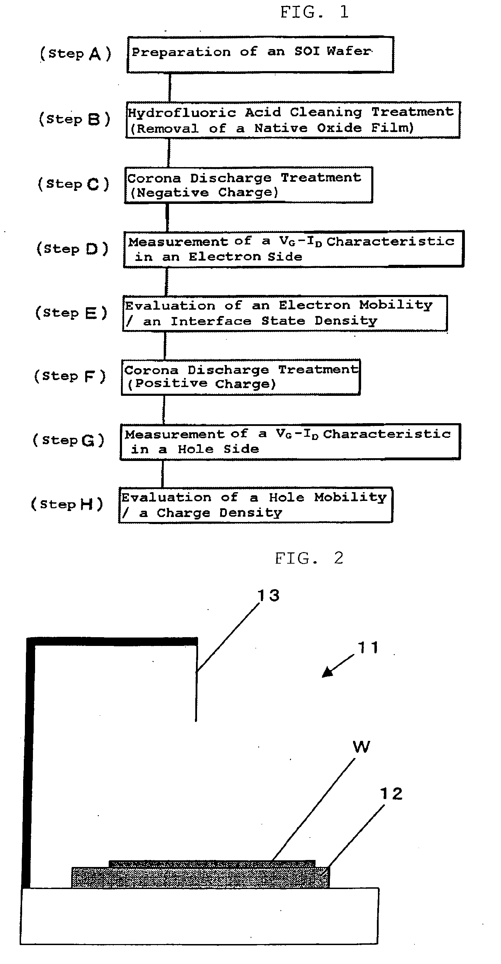

Hereinafter, the method for evaluating an SOI wafer according to the present invention will be explained in detail with reference to drawings. Here, Fig. 1 is a flow chart showing an example of a method for evaluating an SOI wafer according to the present invention. In addition, the flow chart shown in Fig. 1 shows a case of performing a hydrofluoric acid cleaning treatment and then evaluating an electron mobility / an interface state density by measuring a V_{G}-I_{D} characteristic in an electron side of the SOI wafer, and then evaluating a hole mobility / a charge density by measuring a V_{G}-I_{D} characteristic in a hole side thereof. However, the present invention is not limited thereto. As explained in detail as follows, it is possible that Steps A to E are performed to perform only evaluation of an electron mobility / an interface state density, or that Steps C to E are omitted to perform only evaluation of a hole mobility / a charge density, and modification can be appropriately performed according to the purpose.

First, as shown in Fig. 1, an SOI wafer to be an evaluation object is prepared (Step A). The SOI wafer to be an object of the evaluation in the present invention is sufficient, for example, to have an SOI structure in which a buried oxide film to be an insulator layer and an SOI layer are formed above a support wafer. The production method thereof is not limited particularly. For example, as the SOI wafer to be prepared, there can be used an SOI wafer in which polished surfaces of two mirror-polished wafers on which a silicon oxide film is formed on at least one surface of silicon wafers are bonded to each other, and in which then one wafer of them is thinned by grinding and polishing after heat treatment (bonding method). Moreover, there can be used an SOI wafer in which one mirror-polished wafer preliminarily ion-implanted with hydrogen is bonded to another mirror-polished wafer in polished surfaces thereof, and then an SOI structure is formed by delaminating one wafer from the hydrogen-ion implanted layer by performing heat treatment, and then a surface of a thin film to be the SOI layer is polished (hydrogen ion delamination method). Furthermore, there can be also used a so-called SIMOX (Separation by Implanted Oxygen) wafer produced by ion-implanting oxygen into one mirror-polished wafer and then performing a high-temperature heat treatment.

Next, by subjecting the prepared SOI wafer to a hydrofluoric acid cleaning treatment by using an aqueous solution containing HF, a native oxide film formed on an SOI layer surface of the SOI wafer is removed (Step B in Fig. 1). In general, in an SOI wafer, a silicon oxide film having a thin film-thickness called as the native oxide film is formed on the wafer surface by contact with the atmospheric air or the like. The formation of the native oxide film is not uniform on the surface of the SOI wafer, and therefore dispersion in thickness of the oxide film is caused in the wafer plane. Even if such an SOI wafer on which a native oxide film is formed is evaluated as it is, accurate evaluation cannot be performed due to effect such as thickness dispersion of the native oxide film or impurities contained in the native oxide film. Therefore, first, by subjecting the prepared SOI wafer to the hydrofluoric acid cleaning treatment, the native oxide film on the wafer surface is removed.

In the above case, HF concentration in an aqueous solution used in the hydrofluoric acid cleaning treatment is not particularly limited as long as an extent being capable of removing the native oxide film. However, it can be thought that if the HF concentration is too high, a BOX layer lying between the SOI layer and the support wafer also becomes etched. Therefore, it is preferable that the HF concentration is relatively low. For example, it is preferable that an aqueous solution having the HF concentration of 0.5% to 5%, particularly, approximately 1% is used. Also, a cleaning condition such as aqueous solution temperature or cleaning time in performing the hydrofluoric acid cleaning treatment is possible as long as an extent being capable of removing the native oxide film, and can be modified appropriately according to the need.

The SOI wafer subjected to the hydrofluoric acid cleaning treatment with an aqueous solution containing HF as described above is then, for example, rinse-treated by pure water and dried. With respect to the drying method, drying may be performed by blowing a dry air to the SOI wafer or by using such an apparatus as a spin dryer. Or, the drying may be performed by using a chemical solution such as IPA (isopropyl alcohol).

After drying the SOI wafer, the SOI wafer is put on a corona charge apparatus and subjected to a corona discharge treatment, and thereby a charge (negative charge) is loaded on the SOI layer surface of the SOI wafer (Step C in Fig. 1). Fig. 2 is a schematic constitution view showing an example of a corona charge apparatus for subjecting the SOI wafer to the corona discharge treatment. The corona charge apparatus 11 shown in Fig. 2 has a stage 12 and the stage 12 is connected to a motor for X-Y drive as not shown and can be driven in X-Y directions. Moreover, above the stage 12, a charge generation part 13 consisting of a metal wire and generating charge is provided. The charge generation part 13 is fixed so that distance between the end of the charge generation part 13 and the SOI wafer W put on the stage 12 is 1-50 cm, particularly, approximately 20 cm.

In the case of performing the corona discharge treatment by using such a corona charge apparatus 11, after the SOI wafer W is put on the stage 12 so that the SOI layer is upward, negative high voltage is applied to the charge generation part 13 from a high-voltage applying power source (not shown), and thereby negative corona ions are showered on the SOI layer surface of the SOI wafer W from the charge generation part 13. In this case, the negative corona ions are difficult to be generated in the air, and therefore a sealed chamber (not shown) surrounding the corona charge apparatus 11 is preliminarily provided and the inside of the chamber is satisfied with a carbon dioxide gas and then a negative high voltage is applied to the charge generation part 13, and thereby carbon dioxide ions CO₂⁻ can be generated as the negative corona ions. Because such negative corona ions are linearly showered toward the SOI wafer W from the charge generation part 13, a negative charge (negative ions) can be loaded on the entire SOI layer surface of the SOI wafer W by driving the stage 12 in the direction of X or Y.

By loading a negative charge on the SOI layer surface of the SOI wafer, charge state on the SOI layer surface can be rapidly stabilized to be a steady state. In addition, the treatment time of the corona discharge treatment can be appropriately determined according to amount of the charge loaded on the SOI layer surface or the like. However, for example, by performing the corona discharge treatment for approximately 1 min to 30 min particularly approximately 10 min, the charge state on the SOI layer surface can be certainly stabilized.

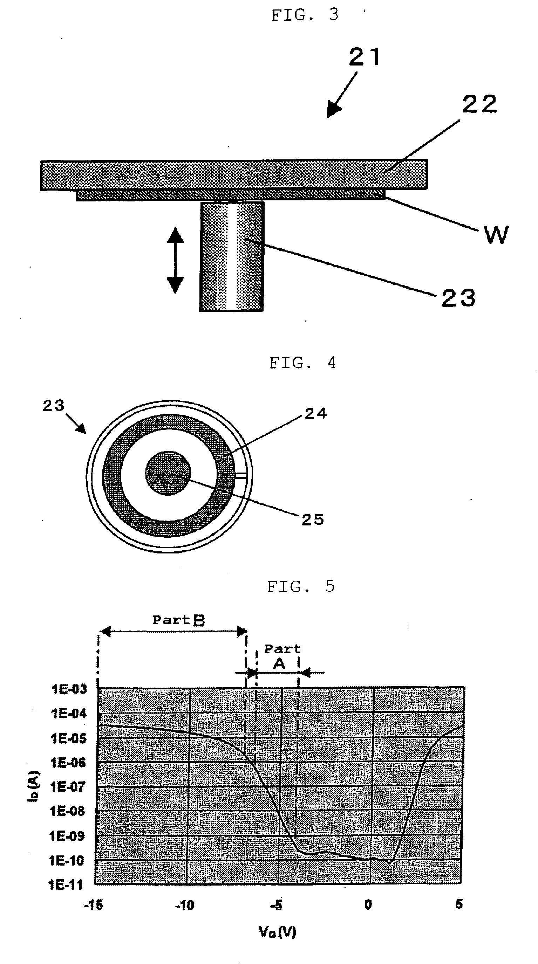

Next, with respect to the SOI wafer W in which a negative charge is loaded on the SOI layer surface as described above, a V_{G}-I_{D} characteristic in an electron side is measured by using a mercury probe apparatus 21 as shown in Fig. 3 (Step D in Fig. 1). For example, the SOI wafer W is put in the apparatus so that the SOI layer thereof is downward namely so that the surface in the SOI layer side is put on a not-shown stage, and then the surface opposite to the surface put on the stage namely the surface in the support wafer side of the SOI wafer is sucked from above with a vacuum chuck 22. The vacuum chuck 22 is made of conductive material such as metal and doubles as a gate electrode.

After the surface in the support wafer side of the SOI wafer W is sucked with the vacuum chuck 22, the stage is moved apart from the SOI wafer W. Then, a mercury probe 23 is approximated to the very vicinity of the SOI layer surface of the SOI wafer W, and only the mercury electrode part is contacted with the SOI layer. In this case, the mercury probe 23 has a structure as shown in Fig. 4 and any one of mercury electrode parts 24, 25 is set to be a source electrode and the other thereof is set to be a drain electrode. In this way, for example, a Pseudo-MOS structure as shown in Fig. 8 can be formed.

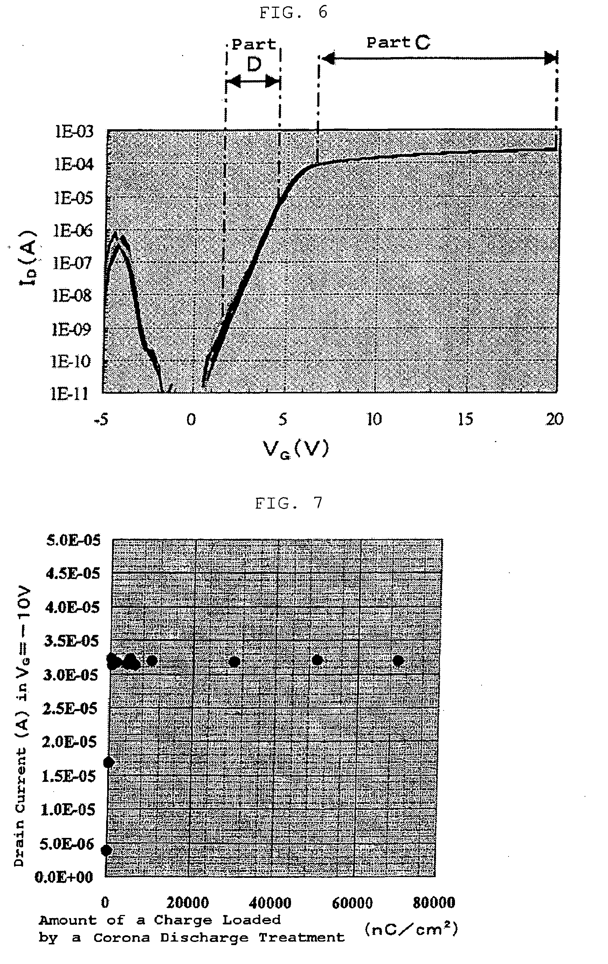

A constant drain voltage is applied in the state in which a Pseudo-MOS structure is formed, and gate voltage is applied and changed in the positive side in the state, and at the same time, change of drain current is monitored, and thereby a relation between the gate voltage V_{G} and the drain current I_{D} in an electron side, namely, the V_{G}-I_{D} characteristic in an electron side, can be measured. The measured V_{G}-I_{D} characteristic in an electron side is, for example, displayed in Fig. 6.

By using, for example, mathematical formulas presented in the above-described Document No. 1 or 2, from gradients of the part C and the part D in the V_{G}-I_{D} characteristic in an electron side measured as Fig. 6, the electron mobility of the SOI layer in the SOI wafer and/or the interface state density between the SOI layer and the buried oxide film can be obtained and evaluated (Step E in Fig. 1). In this case, in the present invention, before measuring a V_{G}-I_{D} characteristic in an electron side in the SOI wafer as described above, a negative charge is loaded on the SOI layer surface by the corona discharge treatment, and the charge state on the SOI layer surface is stabilized, and therefore the measurement of the V_{G}-I_{D} characteristic in an electron side can be stably performed without causing dispersion in measurement value, and the evaluation of an electron mobility or an interface state density can be performed more high-precisely.

In addition, the above-described measurement of a V_{G}- I_{D} characteristic in an electron side (Step D) and the evaluation of an electron mobility / an interface state density (Step E) can be performed in approximately 2 hr by summing the two steps.

Sequentially, after evaluating an electron mobility of the SOI wafer or an interface state density thereof as described above, a positive charge is loaded on the SOI layer surface by subjecting the SOI wafer to a corona discharge treatment (Step F in Fig. 1). The corona discharge treatment by which a positive charge is loaded on the SOI layer surface can be performed by using a corona charge apparatus 11 in Fig. 2 as explained above. For example, the SOI wafer W to be subjected to the corona discharge treatment is put on the stage 12 so that the SOI layer is upward. Then, hydrogen ions (H⁺) are emitted from the charge generation part 13 by applying a positive high voltage to the charge generation part 13, and positive corona ions which are moisture (H₂O) in the air gathering around the hydrogen ion and thereby to be a state of (H₂O)ₙH⁺ are showered on the SOI layer surface of the SOI wafer W, and thereby a positive charge (positive ions) can be loaded on the SOI layer surface of the SOI wafer W.

In the case of loading a positive charge on the SOI layer surface as described above, moisture to form positive corona ions by binding to hydrogen ions exists in large quantity in the air, and therefore a special chamber is not required, for example, in the case of loading a negative charge as explained above. A positive charge can be simply loaded on the SOI layer surface. The corona discharge treatment is performed for approximately 1 min to 30 min particularly approximately 10 min as described above, and thereby a positive charge is loaded on the SOI layer surface of the SOI wafer, and thereby the charge state on the SOI layer surface can be stabilized to be a steady state on a very short time.

After loading a positive charge on the SOI layer surface as described above, a V_{G}-I_{D} characteristic in a hole side of the SOI wafer is measured by using the mercury probe apparatus 21 as shown in Fig. 3 (Step G in Fig. 1). For example, after the surface in the support wafer side of the SOI wafer W is sucked with a vacuum chuck 22, a mercury probe 23 is approximated to the very vicinity of the SOI layer surface of the SOI wafer W, and only the mercury electrode part is contacted with the SOI layer, and thereby a Pseudo-MOS structure is formed. Then, a constant drain voltage is applied from the mercury probe 23 and gate voltage is applied and changed in the negative side in the state, and at the same time, change of drain current is monitored, and thereby a V_{G}-I_{D} characteristic in a hole side can be measured, for example, as shown in fig. 5.

By using mathematical formulas presented in the above-described Document No. 1 or 2, from gradients of the part A and the part B in the V_{G}-I_{D} characteristic in a hole side measured as Fig. 5, the hole mobility of the SOI layer in the SOI wafer and/or the charge density of the BOX layer therein can be obtained and evaluated (Step H in Fig. 1).

In particular, in the present invention, before measuring a V_{G}-I_{D} characteristic in a hole side of the SOI wafer as described above, a positive charge is loaded on the SOI layer surface by the corona discharge treatment and the charge state on the SOI layer surface is stabilized in a short time, and therefore the measurement of a V_{G}-I_{D} characteristic in a hole side can be stably performed without causing dispersion in measurement value, and the evaluation of a hole mobility of the SOI layer or a charge density of the BOX layer can be performed high-precisely in a much shorter time.

In addition, the above-described measurement of a V_{G}-I_{D} characteristic in a hole side (Step G) and the evaluation of a hole mobility / a charge density (Step H) can be performed in approximately 2 hr by summing the two steps.

Here, the present inventors investigated a relation between amount of the charge loaded on the SOI layer surface by the corona discharge treatment and drain current measured by forming a Pseudo-MOS structure. The result thereof is shown in Fig. 7. Fig. 7 is a graph in which values of drain current I_{D} measured in V_{G}=-10V were plotted when the V_{G}-I_{D} characteristics were measured by forming Pseudo-MOS structure in various SOI wafers subjected to the corona discharge treatment by changing amount of the charge.

As shown in Fig. 7, it is found that when amount of the charge loaded on the SOI layer surface by the corona discharge treatment is 500 nC/cm² or more, drain current is very stable. Therefore, it is preferable that amount of the charge loaded on the SOI layer surface by a corona discharge treatment is 500 nC/cm² or more. Thereby, the charge state on the SOI layer surface can be very effectively stabilized in a short time. On the other hand, even when the amount of the charge loaded on the SOI layer surface set to be too large, the drain current is stable at a constant value. Therefore, it is assumed that more effect is difficult to be obtained, and on the contrary, it is thought that burden to the corona charge apparatus used in the corona discharge treatment becomes large or burden to cost becomes large. Therefore, it is preferable that amount of the charge loaded on the SOI layer surface by a corona discharge treatment is 50000 nC/cm² or less, particularly, 3000 nC/cm² or less.

As described above, according to the method for evaluating an SOI wafer of the present invention, after removing a native oxide film on the SOI wafer surface by subjecting the SOI wafer to the hydrofluoric acid cleaning treatment, a charge is loaded on the SOI layer surface by performing the corona discharge treatment, and thereby charge state on the SOI layer surface can be rapidly stabilized to be a steady state, and then the SOI wafer in which the charge state on the SOI layer surface is stabilized is contacted with the mercury probe, and thereby a V_{G}-I_{D} characteristic is measured and electric characteristics of the SOI wafer such as electron mobility, interface state density, hole mobility, and BOX layer charge density, can be evaluated. Thereby, a large-scale apparatus and multiple steps such as a photolithography process are not required and evaluation of an SOI wafer can be very simply performed by using a mercury probe. Moreover, because charge state on the SOI layer surface is very stable in measuring a V_{G}-I_{D} characteristic, dispersion of measurement value can be reduced and highly reliable evaluation of an SOI wafer can be stably performed high-precisely.

In particular, in the case of evaluating a hole mobility of the SOI wafer or a BOX layer charge density thereof, in a conventional method without being rested for 10-12 hr or more before measuring the V_{G}-I_{D} characteristic by a mercury probe, the charge state on the SOI layer surface is not stabilized and therefore the V_{G}-I_{D} characteristic cannot be measured accurately. However, according to the present invention, the charge state can be stabilized in a short time of approximately 10 min by performing the corona discharge treatment. Therefore, according to the present invention, in particular, when a hole mobility or a BOX layer charge density is evaluated, the evaluation time of an SOI wafer can be drastically shortened as compared to that of a conventional method, and also operation rate of measurement apparatus can be improved, and therefore the evaluation of an SOI wafer can be performed very effectively, and furthermore administration of the SOI wafer in performing the evaluation also becomes much easier than that of a conventional method.

In addition, the method for evaluating an SOI wafer of the present invention is not limited to such steps as shown in the flow chart of Fig. 1, and modification or deletion of the steps can be appropriately performed according to the need or purpose.

For example, in the case that evaluation of electron mobility and interface state density and hole mobility and BOX layer charge density is required to be performed at lower cost, for example, the corona discharge treatment for a negative charge as shown in Step C in Fig. 1 may be omitted and a V_{G}-I_{D} characteristic in an electron side may be measured immediately after the hydrofluoric acid cleaning treatment. For performing the corona discharge treatment for a negative charge, a sealed chamber is required for filling a carbon dioxide gas (for example, CO₂⁻) around the corona charge apparatus as described above. Therefore, by omitting this step, it becomes possible that cost for producing an apparatus is drastically lowered. Moreover, with respect to the V_{G}-I_{D} characteristic in an electron side, measurement data is relatively stable if measured immediately after the removal of the native oxide film, and therefore it is possible that an electron mobility and/or an interface state density can be measured accurately. Furthermore, according to cases, in the corona discharge treatment of Step C in Fig. 1, not a negative charge but a positive charge can be also loaded on the SOI layer surface.

Furthermore, in the case of performing only evaluation of an electron mobility of the SOI wafer and/or an interface state density thereof, Steps A-E in Fig. 1 may be performed in order. On the other hand, in the case of performing only evaluation of a hole mobility of the SOI wafer and/or a charge density of the BOX layer thereof, Steps F-H may be performed without performing Steps C-E after performing Steps A and B. In this case, as described above, if the V_{G}-I_{D} characteristic in a hole side is measured immediately after the removal of the native oxide film, a long time is required until measurement value is stabilized. Therefore, it is necessary to perform the corona discharge treatment of Step F.

Moreover, according to the need, it is possible that two SOI wafers produced under the same condition in Step A are prepared, and one SOI wafer is subjected to Steps B-E in order, and thereby the evaluation of an electron mobility and/or an interface state density is performed, and the other SOI wafer is subjected to Steps B and F-H in order, and thereby the evaluation of a hole mobility and/or a charge density of the BOX layer is performed. When two SOI wafers are prepared and evaluated separately to each other, sweep of gate voltage is sufficient to be performed only in the positive side or the negative side, and therefore the evaluation of an SOI wafer can be performed in a much shorter time, and also stress applied to the SOI wafer can be reduced.

Furthermore, in the present invention, the evaluation of an SOI wafer may be performed by interchanging Steps C-E and Steps F-H in Fig. 1. That is, it is also possible that after the SOI wafer is prepared and subjected to the hydrofluoric acid cleaning treatment (Steps A and B), first, the evaluation of a hole mobility / a BOX layer charge density is performed by performing Steps F-H, and then the evaluation of an electron mobility / an interface state density is performed by performing Steps C-E. In this case, it is preferable that, for example, after performing the evaluation of a hole mobility / a BOX layer charge density in Step H, the positive charge on the SOI layer surface is removed by performing a cleaning treatment of the SOI wafer or the like, and then Steps C-E is performed. By performing the treatment of removing the positive charge on the SOI layer surface after performing Steps F-H before performing Steps C-E, the electron mobility or the interface state density can be evaluated more high-precisely with high reliability. In addition, in the case of evaluating the SOI wafer by interchanging Steps C-E and Steps F-H in Fig. 1 as described above, for example, the corona discharge treatment for a negative charge of Step C can be omitted for reducing cost.

Fig. 9 is a flow chart showing another example of the method for evaluating an SOI wafer according to the present invention. In addition, the flow chart shown in Fig. 9 shows a case that after performing a hydrofluoric acid cleaning treatment, the electron mobility / the interface state density is evaluated by measuring the V_{G}-I_{D} characteristic in an electron side of the SOI wafer, and then an oxide film is formed on the SOI layer surface, and the hole mobility / the charge density is evaluated by measuring the V_{G}-I_{D} characteristic in a hole side. However, the present invention is not limited thereto at all. As explained in detail as follows, formation of an oxide film of Step E may be performed between Step B and Step C, or only the evaluation of a hole mobility / an electron density may be performed by omitting Step C and Step D, and modification can be appropriately performed according to the purpose.

First, as shown in Fig. 9, an SOI wafer to be an evaluation object is prepared (Step A). The SOI wafer to be an object of the evaluation in the present invention is sufficient, for example, to have an SOI structure in which a buried oxide film to be an insulator layer and an SOI layer are formed above a support wafer. The production method thereof is not limited particularly. For example, as the SOI wafer to be prepared, there can be used an SOI wafer in which polished surfaces of two mirror-polished wafers on which a silicon oxide film is formed on at least one surface of silicon wafers are bonded to each other, and in which then one wafer of them is thinned by grinding and polishing after heat treatment (bonding method). Moreover, there can be used an SOI wafer in which one mirror-polished wafer preliminarily ion-implanted with hydrogen is bonded to another mirror-polished wafer in polished surfaces thereof, and then an SOI structure is formed by delaminating one wafer from the hydrogen-ion implanted layer by performing heat treatment, and then a surface of a thin film to be the SOI layer is polished (hydrogen ion delamination method). Furthermore, there can be also used a so-called SIMOX wafer produced by ion-implanting oxygen into one mirror-polished wafer and then performing a high-temperature heat treatment.

Next, by subjecting the prepared SOI wafer to a hydrofluoric acid cleaning treatment by using an aqueous solution containing HF, a native oxide film formed on a surface of the SOI wafer is removed (Step B in Fig. 9). In general, in an SOI wafer, a silicon oxide film having a thin film-thickness called as the native oxide film is formed on the wafer surface by contact with the atmospheric air or the like. The formation of the native oxide film is not uniform on the surface of the SOI wafer, and therefore dispersion in thickness of the oxide film is caused in the wafer plane. Even if such an SOI wafer on which a native oxide film is formed is evaluated as it is, accurate evaluation cannot be performed due to effect such as thickness dispersion of the native oxide film or impurities contained in the native oxide film. Therefore, first, by subjecting the prepared SOI wafer to the hydrofluoric acid cleaning treatment, the native oxide film on the wafer surface is removed.

In the above case, HF concentration in an aqueous solution used in the hydrofluoric acid cleaning treatment is not particularly limited as long as an extent being capable of removing the native oxide film. However, it can be thought that if the HF concentration is too high, a BOX layer lying between the SOI layer and the support wafer also becomes etched. Therefore, it is preferable that the HF concentration is relatively low. For example, it is preferable that an aqueous solution having the HF concentration of 0.5% to 5%, particularly, approximately 1% is used. Also, a cleaning condition such as aqueous solution temperature or cleaning time in performing the hydrofluoric acid cleaning treatment is possible as long as an extent being capable of removing the native oxide film, and can be modified appropriately according to the need.

The SOI wafer subjected to the hydrofluoric acid cleaning treatment with an aqueous solution containing HF as described above is then, for example, rinse-treated by pure water in which dissolved oxygen is reduced as much as possible, and dried. In the rinse treatment, by using the pure water in which dissolved oxygen is reduced as much as possible as described above, it can be suppressed that a native oxide film is formed on the SOI wafer again. Moreover, with respect to the drying method, drying may be performed by blowing a dry air having a reduced moisture concentration to the SOI wafer or by using such an apparatus as a spin dryer. Or, the drying may be performed by using a chemical solution such as IPA.

With respect to the SOI wafer in which the native oxide film is removed by performing the hydrofluoric acid cleaning treatment as described above, the V_{G}-I_{D} characteristic in an electron side is immediately measured by using a mercury probe apparatus 21 as shown in Fig. 3 (Step C in Fig. 9). For example, the SOI wafer W is put in the apparatus so that the SOI layer thereof is downward namely so that the surface in the SOI layer side is put on a not-shown stage, and then the surface opposite to the surface put on the stage namely the surface in the support wafer side of the SOI wafer is sucked from above with a vacuum chuck 22. The vacuum chuck 22 is made of conductive material such as metal and doubles as a gate electrode.

After the surface in the support wafer side of the SOI wafer W is sucked with the vacuum chuck 22, the stage is moved apart from the SOI wafer W. Then, a mercury probe 23 is approximated to the very vicinity of the SOI layer surface of the SOI wafer W, and only the mercury electrode part is contacted with the SOI layer. In this case, the mercury probe 23 has a structure as shown in Fig. 4 and any one of mercury electrode parts 24, 25 is set to be a source electrode and the other thereof is set to be a drain electrode. In this way, for example, a Pseudo-MOS structure as shown in Fig. 8 can be formed.

A constant drain voltage is applied in the state in which a Pseudo-MOS structure is formed, and gate voltage is applied and changed in the positive side in the state, and at the same time, change of drain current is monitored, and thereby a relation between the gate voltage V_{G} and the drain current I_{D} in an electron side, namely, the V_{G}-I_{D} characteristic in an electron side, can be measured. The measured V_{G}-I_{D} characteristic in an electron side is, for example, displayed in Fig. 6.

By using, for example, mathematical formulas presented in the above-described Document No. 1 or 2, from gradients of the part C and the part D in the V_{G}-I_{D} characteristic in an electron side measured as Fig. 6, the electron mobility of the SOI layer in the SOI wafer and/or the interface state density between the SOI layer and the buried oxide film can be obtained and evaluated (Step D in Fig. 9). In this case, in the present invention, after removing the native oxide film, a V_{G}-I_{D} characteristic in an electron side of the SOI wafer can be immediately measured as described above. When the V_{G}-I_{D} characteristic in an electron side is measured immediately after the removal of the native oxide film as described above, the measurement data are relatively stable. Therefore, the electron mobility and/or the interface state density can be measured accurately.

In addition, the above-described measurement of a V_{G}-I_{D} characteristic in an electron side (Step C) and the evaluation of an electron mobility / an interface state density (Step D) can be performed in approximately 2 hr by summing the two steps.

Sequentially, after evaluating an electron mobility of the SOI wafer or an interface state density thereof as described above, a silicon oxide film is newly formed on the SOI layer surface of the SOI wafer (Step E in Fig. 9). The formation of an oxide film can be easily performed by heat-treating the SOI wafer. By forming an oxide film by heat-treating the SOI wafer as described above, a thickness of the oxide film to be formed can be controlled easily and high-precisely and the oxide film having a desired film-thickness can be stably formed on the SOI layer surface. By forming the oxide film on the SOI layer surface of the SOI wafer by the heat treatment as described above, charge state on the SOI layer surface can be rapidly stabilized, and also the film-thickness of the formed silicon oxide film can be uniform in the wafer plane, and therefore, then in measuring a V_{G}-I_{D} characteristic in a hole side by contacting such a mercury probe as explained as follows, dispersion in measurement value is not caused, and the electric characteristic can be measured high-precisely.

In this case, it is preferable that thickness of the oxide film formed on the SOI layer surface is 5 nm or less. When the oxide film formed on the SOI layer surface has a very thin thickness, 5 nm or less, electricity can be certainly passed through the oxide film by tunnel effect of the silicon oxide film having a thin thickness in sequentially measuring the V_{G}-I_{D} characteristic in a hole side. Therefore, the electric characteristic of an SOI wafer can be measured accurately. On the other hand, it is preferable that the thickness of the oxide film formed on the SOI layer surface is 0.1 nm or more, and thereby charge state on the SOI layer surface can be certainly stabilized.

Moreover, in the above case, it is preferable that the heat treatment of the SOI wafer is performed at temperature of 50°C to 350°C. When the heat treatment of the SOI wafer is performed at temperature of 50°C or more, a silicon oxide film can be formed uniformly and very stably on the SOI layer surface without causing dispersion in film-thickness thereof. On the other hand, it can be thought that if the heat treatment temperature is more than 350°C, the formation of the silicon oxide film on the SOI layer rapidly proceeds and, for example, the film-thickness of the oxide film becomes more than 5 nm. Therefore, it is preferable that the heat treatment of the SOI wafer is performed at 350°C or less, and thereby the silicon oxide film can be easily formed so as to have a desired film-thickness, particularly, a film-thickness of 5 nm or less.

Furthermore, the heat treatment for forming the oxide film on the SOI wafer may be performed in an atmosphere containing oxygen, and particularly, it is preferable that the heat treatment is performed in an air or a 100% oxygen atmosphere.

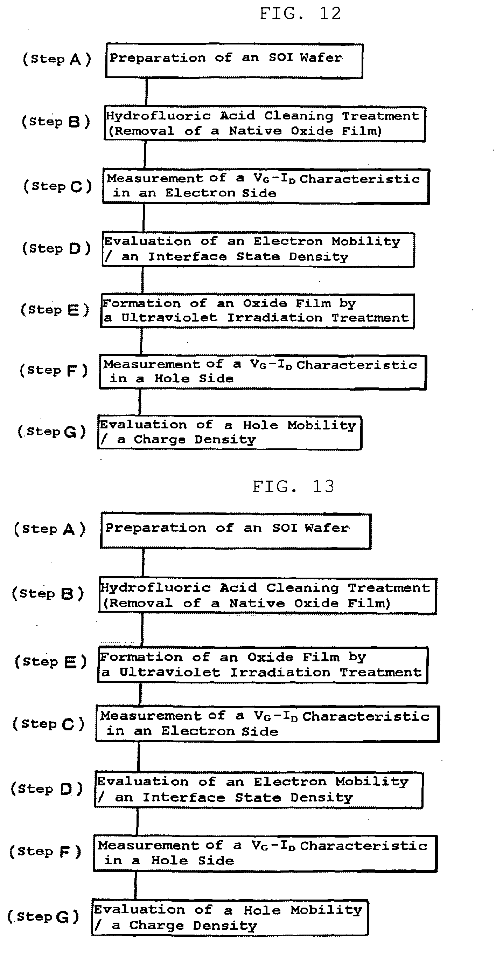

That is, when an air is used as the atmosphere containing oxygen in heat-treating the SOI wafer, a major-scale apparatus such as a heat treatment furnace insulating the heat treatment atmosphere from outside or the like is not required, and the SOI wafer W can be heat-treated by using a simple apparatus such as a hot plate 31 as shown in Fig. 11. The hot plate 31 as shown in Fig. 11 is provided with a heater 33 under a flat metal plate 32 subjected to surface treatment. For example, the SOI wafer W is put on the metal plate 32 and the SOI wafer W is heated to a desired temperature with the heater 33, and thereby the SOI wafer W can be subjected to the heat treatment in the air. The SOI wafer W is subjected to the heat treatment by using the hot plate 31 having such a simple structure, and thereby the oxide film having a desired film-thickness can be stably formed on the SOI layer surface. In addition, in the case of heat-treating the SOI wafer in an air by using the hot plate or the like as described above, for forming, for example, the silicon oxide film of 5 nm or less on the SOI layer surface, the oxide film having the desired film-thickness can be formed uniformly in approximately 1-30 min, particularly approximately 10 min, although depending on the heat treatment temperature. Therefore, charge state on the SOI layer surface can be stabilized in a short time.

On the other hand, in the case of performing the above-described heat treatment by using, for example, a general heat treatment furnace or a RTA (Rapid Thermal Anneal) apparatus, the heat treatment atmosphere can be voluntarily controlled with being insulated from outside, and therefore it becomes possible to use atmosphere having a higher oxygen partial pressure than that of an air, and the SOI wafer can be easily heat-treated in a 100% oxygen atmosphere. By heat-treating the SOI wafer in a 100% oxygen atmosphere as described above, the formation of the uniform oxide film proceeds rapidly even in a relatively low temperature, and therefore the heat treatment time can be shortened in itself, and also temperature lowering of the heat treatment temperature can be planned. Moreover, in the case of heat-treating the SOI wafer in such a 100% oxygen atmosphere, for forming, for example, the silicon oxide film of 5 nm or less on the SOI layer surface, the oxide film having the desired film-thickness can be formed uniformly in approximately 1-10 min, particularly approximately 5 min. Therefore, charge state on the SOI layer surface can be stabilized in a very short time.

After forming the oxide film having a desired film-thickness uniformly on the SOI layer surface as described above, a V_{G}-I_{D} characteristic in a hole side of the SOI wafer is measured by using a mercury probe apparatus 21 as shown in Fig. 3 (Step F in Fig. 9). For example, after the surface in the support wafer side of the SOI wafer W is sucked with a vacuum chuck 22, a mercury probe 23 is approximated to the very vicinity of the SOI layer surface of the SOI wafer W, and only the mercury electrode part is contacted with the SOI layer, and thereby, a Pseudo-MOS structure is formed. Then, a constant drain voltage is applied from the mercury probe 23 and gate voltage is applied and changed in the negative side in the state, and at the same time, change of drain current is monitored, and thereby a V_{G}-I_{D} characteristic in a hole side can be measured, for example, as shown in Fig. 5.

By using mathematical formulas presented in the above-described Document No. 1 or 2, from gradients of the part A and the part B in the V_{G}-I_{D} characteristic in a hole side measured as Fig. 5, the hole mobility of the SOI layer in the SOI wafer and/or the charge density of the BOX layer therein can be obtained and evaluated (Step G in Fig. 9).

In particular, in the present invention, before measuring a V_{G}-I_{D} characteristic in a hole side of the SOI wafer as described above, charge state on the SOI layer surface is stabilized in a short time by forming the oxide film uniformly on the SOI layer surface by performing the heat treatment. Therefore, the measurement of a V_{G}-I_{D} characteristic in a hole side can be stably performed without causing dispersion in measurement value and the evaluation of a hole mobility of the SOI layer or a charge density of the BOX layer can be performed more high-precisely in a short time.

In addition, the above-described measurement of a V_{G}- I_{D} characteristic in a hole side (Step F) and the evaluation of a hole mobility / a charge density (Step G) can be performed in approximately 2 hr by summing the two steps.

Moreover, in the present invention, for example, between the hydrofluoric acid cleaning treatment (Step B) and the measurement of a V_{G}-I_{D} characteristic in an electron side (Step C) in the flow chart shown in Fig. 9, the formation of an oxide film (Step E) in which an oxide film is formed on the SOI layer surface can be further added.

As described above, according to the method for evaluating an SOI wafer of the present invention, after removing a native oxide film on the SOI wafer surface by subjecting the SOI wafer to a hydrofluoric acid cleaning treatment, by forming newly, for example, an oxide film having a film thickness of 5 nm or less on the SOI layer surface, charge state on the SOI layer surface can be rapidly stabilized to be a steady state, and then, the SOI wafer in which charge state on the SOI layer surface is stable is contacted with a mercury probe and a V_{G}-I_{D} characteristic is measured, and thereby an electric characteristic of the SOI wafer such as a hole mobility or a BOX layer charge density, or further, an electron mobility or an interface state density, can be evaluated high-precisely. Thereby, a large-scale apparatus and multiple steps such as a photolithography process are not required and evaluation of an SOI wafer can be very simply performed by using a mercury probe. Moreover, charge state on the SOI layer surface is very stable in measuring a V_{G}-I_{D} characteristic, and also a film-thickness of the silicon oxide film is uniform in the wafer plane. Therefore, highly reliable evaluation of an SOI wafer can be stably performed without causing dispersion in measurement value.

In particular, in the case of evaluating a hole mobility of the SOI wafer or a BOX layer charge density thereof, in a conventional method without being rested for 10-12 hr or more before measuring the V_{G}-I_{D} characteristic by a mercury probe, the charge state on the SOI layer surface is not stabilized and therefore the V_{G}-I_{D} characteristic cannot be measured accurately. However, according to the present invention, the charge state can be stabilized in a short time of approximately 30 min or less, particularly approximately 10 min or less by forming an oxide film on the SOI layer surface. Therefore, according to the present invention, in particular, when a hole mobility or a BOX layer charge density is evaluated, the evaluation time of the SOI wafer can be drastically shortened as compared to that of a conventional method, and also operation rate of measurement apparatus can be improved, and therefore evaluation of an SOI wafer can be performed very effectively, and furthermore, administration of the SOI wafer in performing the evaluation also becomes much easier than that of a conventional method.

In addition, the method for evaluating an SOI wafer of the present invention is not limited to such steps as shown in the flow chart of Fig. 9, and modification or deletion of the steps can be appropriately performed according to the need or purpose.

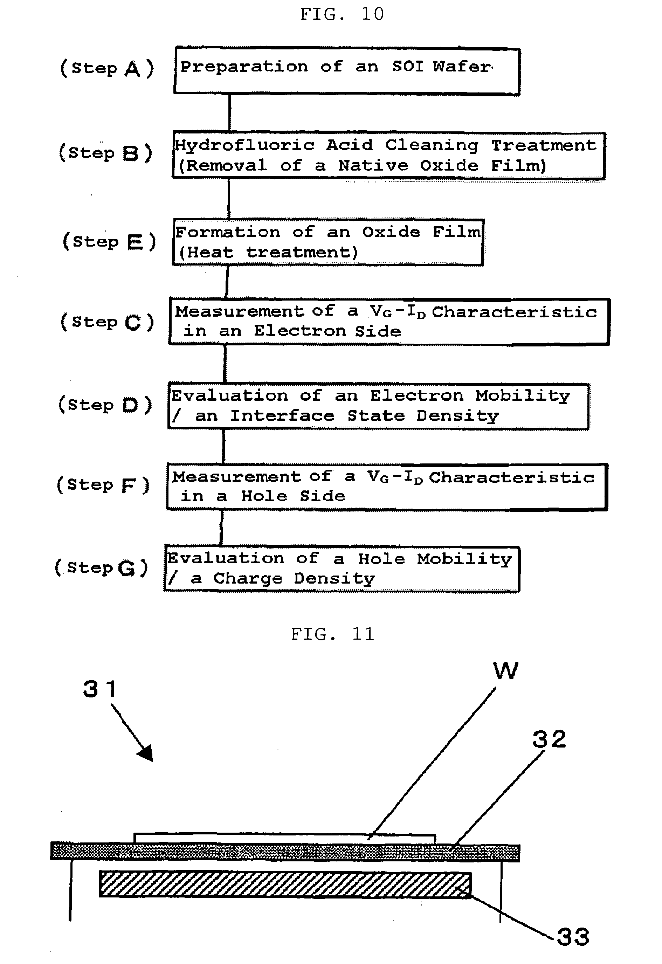

For example, as described above, between the hydrofluoric acid cleaning treatment (Step B) and the measurement of a V_{G}-I_{D} characteristic in an electron side (Step C), the formation of an oxide film (Step E) in which an oxide film is formed on the SOI layer surface can be added. Moreover, for example, as shown in Fig. 10, it is also possible that the formation of an oxide film of Step E is performed immediately after the hydrofluoric acid cleaning treatment (Step B), and that then the evaluation of the SOI wafer can be performed by performing Steps C, D, F, and G, in order, without performing the formation of an oxide film. As shown in Fig. 10, by forming the oxide film on the SOI layer surface immediately after the hydrofluoric acid cleaning treatment, in measuring the V_{G}-I_{D} characteristic in an electron side or in measuring the V_{G}-I_{D} characteristic in a hole side, charge state on the SOI layer surface is stable, and also effect of an native oxide film in danger of being formed in the measurement can be certainly excluded, and the measurement can be stably performed without causing dispersion in measurement value. Therefore, it becomes possible that the evaluation of the electron mobility / the interface state density and the hole mobility /the charge density can be performed high-precisely.

Furthermore, in the present invention, in the case of performing, for example, only evaluation of an electron mobility of the SOI wafer and/or an interface state density thereof, it is possible, for example, that Steps A, B, E, C, D as shown in Fig. 10 are performed in order and that then the evaluation of the SOI wafer is finished. On the other hand, in the case of performing only evaluation of a hole mobility of the SOI wafer and/or a charge density of a BOX layer thereof, it is possible that Steps C and D in the flow chart shown in Fig. 9 are omitted and Steps E-G is performed immediately after performing Steps A and B. In this case, as described above, if the V_{G}-I_{D} characteristic in a hole side is measured immediately after the removal of the native oxide film, a long time is required until measurement value is stabilized. Therefore, it is necessary to perform the formation of an oxide film by the heat treatment of Step E.

Moreover, according to the need, it is possible that two SOI wafers produced under the same condition in Step A are prepared, and one SOI wafer is subjected to Steps B, E, C, and D, in order, and thereby the evaluation of an electron mobility and/or an interface state density is performed, and, the other SOI wafer is subjected to Steps B, E, F, and G, in order, and thereby the evaluation of a hole mobility and/or a charge density of the BOX layer is performed. When two SOI wafers are prepared and evaluated separately to each other, sweep of gate voltage is sufficient to be performed only in the positive side or the negative side. Therefore, the evaluation of an SOI wafer can be performed in a much shorter time, and also stress applied to the SOI wafer can be reduced.

Furthermore, in the present invention, the evaluation of the SOI wafer may be performed by interchanging Steps C and D and Steps E-G in Fig. 9. That is, it is also possible that after the SOI wafer is prepared and subjected to the hydrofluoric acid cleaning treatment (Steps A and B), charge state on the SOI layer surface is rapidly stabilized by forming an oxide film on the SOI layer surface by performing, for example, a heat treatment, and then the evaluation of a hole mobility / a BOX layer charge density is performed by performing Steps F and G, and then the evaluation of an electron mobility / an interface state density is performed by performing Steps C and D.

That is, with respect to the present invention, it is sufficient that after the hydrofluoric acid cleaning treatment, the silicon oxide film can be formed on the SOI layer surface before measuring the V_{G}-I_{D} characteristic, particularly before measuring the V_{G}-I_{D} characteristic in a hole side. And, thereby, the charge state on the SOI layer surface can be stabilized in a short time, and therefore it is not necessary that the SOI wafer is stored for 10-12 hr or more before measuring the V_{G}-I_{D} characteristic as a conventional method, and the SOI wafer can be evaluated very effectively. Therefore, in the present invention, for example, there is no problem even when either the evaluation of a V_{G}-I_{D} characteristic in an electron side or the evaluation of a V_{G}-I_{D} characteristic in a hole side is first performed.

Fig. 12 is a flow chart showing further another example of the method for evaluating an SOI wafer according to the present invention. In addition, the flow chart shown in Fig. 12 shows a case that after performing a hydrofluoric acid cleaning treatment, the electron mobility / the interface state density is evaluated by measuring the V_{G}-I_{D} characteristic in an electron side of the SOI wafer, and then an oxide film is formed on the SOI layer surface, and the hole mobility / the charge density is evaluated by measuring the V_{G}- I_{D} characteristic in a hole side. However, the present invention is not limited thereto at all. As explained in detail as follows, formation of an oxide film by an ultraviolet irradiation treatment of Step E may be performed between Step B and Step C, or only the evaluation of a hole mobility / a charge density may be performed by omitting Step C and Step D, and modification can be appropriately performed according to the purpose.

First, as shown in Fig. 12, an SOI wafer to be an evaluation object is prepared (Step A). The SOI wafer to be an object of the evaluation in the present invention is sufficient, for example, to have an SOI structure in which a buried oxide film to be an insulator layer and an SOI layer are formed above a support wafer. The production method thereof is not limited particularly. For example, as the SOI wafer to be prepared, there can be used an SOI wafer in which polished surfaces of two mirror-polished wafers on which a silicon oxide film is formed on at least one surface of silicon wafers are bonded to each other, and in which then one wafer of them is thinned by grinding and polishing after heat treatment (bonding method). Moreover, there can be used an SOI wafer in which one mirror-polished wafer preliminarily ion-implanted with hydrogen is bonded to another mirror-polished wafer in polished surfaces thereof, and then an SOI structure is formed by delaminating one wafer from the hydrogen-ion implanted layer by performing heat treatment, and then a surface of a thin film to be the SOI layer is polished (hydrogen ion delamination method). Furthermore, there can be also used a so-called SIMOX wafer produced by ion-implanting oxygen into one mirror-polished wafer and then performing a high-temperature heat treatment.

Next, by subjecting the prepared SOI wafer to a hydrofluoric acid cleaning treatment by using an aqueous solution containing HF, a native oxide film formed on a surface of the SOI wafer is removed (Step B in Fig. 12). In general, in an SOI wafer, an oxide film having a thin film-thickness called as the native oxide film is formed on the wafer surface by contact with the atmospheric air or the like. The formation of the native oxide film is not uniform on the surface of the SOI wafer, and therefore dispersion in thickness of the oxide film is caused in the wafer plane. Even if such an SOI wafer on which a native oxide film is formed is evaluated as it is, accurate evaluation cannot be performed due to effect such as thickness dispersion of the native oxide film or impurities contained in the native oxide film. Therefore, first, by subjecting the prepared SOI wafer to the hydrofluoric acid cleaning treatment, the native oxide film on the wafer surface is removed.

In the above case, HF concentration in an aqueous solution used in the hydrofluoric acid cleaning treatment is not particularly limited as long as an extent being capable of removing the native oxide film. However, it can be thought that if the HF concentration is too high, a BOX layer lying between the SOI layer and the support wafer also becomes etched. Therefore, it is preferable that the HF concentration is relatively low. For example, it is preferable that an aqueous solution having the HF concentration of 0.5% to 5%, particularly, approximately 1% is used. Also, a cleaning condition such as aqueous solution temperature or cleaning time in performing the hydrofluoric acid cleaning treatment is possible as long as an extent being capable of removing the native oxide film, and can be modified appropriately according to the need.

The SOI wafer subjected to the hydrofluoric acid cleaning treatment with an aqueous solution containing HF as described above is then, for example, rinse-treated by pure water in which dissolved oxygen is reduced as much as possible, and dried. In the rinse treatment, by using the pure water in which dissolved oxygen is reduced as much as possible as described above, it can be suppressed that a native oxide film is formed on the SOI wafer again. Moreover, with respect to the drying method, drying may be performed by blowing a dry air having a reduced moisture concentration to the SOI wafer or by using such an apparatus as a spin dryer. Or, the drying may be performed by using a chemical solution such as IPA.

With respect to the SOI wafer in which the native oxide film is removed by performing the hydrofluoric acid cleaning treatment as described above, the V_{G}-I_{D} characteristic in an electron side is immediately measured by using a mercury probe apparatus 21 as shown in Fig. 3 (Step C in Fig. 12). For example, the SOI wafer W is put in the apparatus so that the SOI layer thereof is downward namely so that the surface in the SOI layer side is put on a not-shown stage, and then the surface opposite to the surface put on the stage namely the surface in the support wafer side of the SOI wafer is sucked from above with a vacuum chuck 22. The vacuum chuck 22 is made of conductive material such as metal and doubles as a gate electrode.

After the surface in the support wafer side of the SOI wafer W is sucked with the vacuum chuck 22, the stage is moved apart from the SOI wafer W. Then, a mercury probe 23 is approximated to the very vicinity of the SOI layer surface of the SOI wafer W, and only the mercury electrode part is contacted with the SOI layer. In this case, the mercury probe 23 has a structure as shown in Fig. 4 and any one of mercury electrode parts 24, 25 is set to be a source electrode and the other thereof is set to be a drain electrode. In this way, for example, a Pseudo-MOS structure as shown in Fig. 8 can be formed.

A constant drain voltage is applied in the state in which a Pseudo-MOS structure is formed, and gate voltage is applied and changed in the positive side in the state, and at the same time, change of drain current is monitored, and thereby a relation between the gate voltage V_{G} and the drain current I_{D} in an electron side, namely, the V_{G}-I_{D} characteristic in an electron side, can be measured. The measured V_{G}-I_{D} characteristic in an electron side is, for example, displayed in Fig. 6.

By using, for example, mathematical formulas presented in the above-described Document No. 1 or 2, from gradients of the part C and the part D in the V_{G}-I_{D} characteristic in an electron side measured as Fig. 6, the electron mobility of the SOI layer in the SOI wafer and/or the interface state density between the SOI layer and the buried oxide film can be obtained and evaluated (Step D in Fig. 12). In this case, in the present invention, after removing the native oxide film, a V_{G}-I_{D} characteristic in an electron side of the SOI wafer can be immediately measured as described above. When the V_{G}-I_{D} characteristic in an electron side is measured immediately after the removal of the native oxide film as described above, the measurement data are relatively stable. Therefore, the electron mobility and/or the interface state density can be measured accurately.

In addition, the above-described measurement of a V_{G}-I_{D} characteristic in an electron side (Step C) and the evaluation of an electron mobility / an interface state density (Step D) can be performed in approximately 2 hr by summing the two steps.

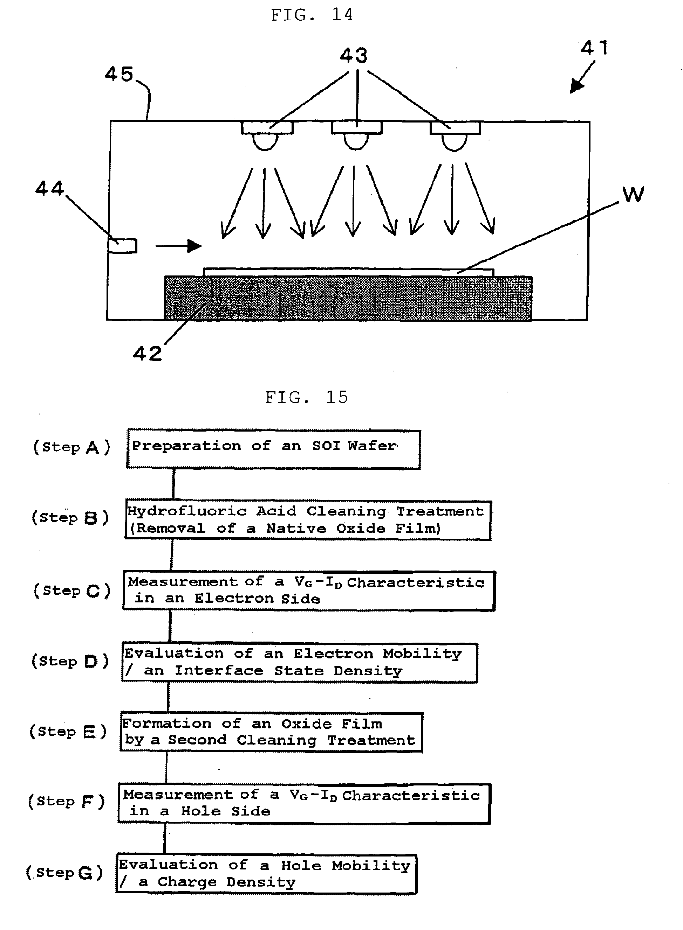

Sequentially, after evaluating an electron mobility of the SOI wafer or an interface state density thereof as described above, a silicon oxide film is formed on the SOI layer surface of the SOI wafer by subjecting the SOI wafer to an ultraviolet irradiation treatment (Step E in Fig. 12). The ultraviolet irradiation treatment can be performed, for example, by using an ultraviolet treatment apparatus 41 as shown in Fig. 14. The ultraviolet treatment apparatus 41 as shown in Fig. 14 has a stage 42 on which the SOI wafer W is put and an ultraviolet generating lamp 43 such as a mercury lamp generating ultraviolet rays in a chamber 45, and furthermore, an atmospheric-gas supply duct 44 for supplying an atmospheric gas is provided in the chamber 45.

In the case of subjecting the SOI wafer to an ultraviolet irradiation treatment by using such an ultraviolet treatment apparatus 41, after putting the SOI wafer W on the stage 42 so that the SOI layer thereof is upward, the SOI layer surface of the SOI wafer W is irradiated with ultraviolet rays from the ultraviolet generating lamp 43, and thereby a silicon oxide film having a desired film-thickness can be formed uniformly on the SOI layer surface.

Here, reaction of ultraviolet rays and oxygen is explained. The ultraviolet rays generated from the ultraviolet generating lamp 43 of the ultraviolet treatment apparatus 41 reacts with an oxygen molecule in the chamber 45 to generate oxygen radicals (O₂ + hυ(184.9 nm) → O + O). The oxygen radial reacts with an oxygen molecule to generate ozone (O₂ + O → O₃). By irradiating ultraviolet rays in the SOI layer vicinity, the ozone generated by the reaction with the oxygen radical is decomposed into an oxygen molecule and an excited oxygen atom (hυ (253.7 nm) + O₃ → O₂ + O*). The decomposed excited oxygen atoms and silicon in the SOI layer react, and thereby the silicon oxide film can be formed on the SOI layer surface so that film-thickness thereof is uniform in the wafer plane (Si + 20* → SiO₂) .

In such an ultraviolet irradiation treatment, the ultraviolet rays irradiated from the ultraviolet generating lamp 43 is not particularly limited as long as having wavelength being capable of forming the silicon oxide film on the SOI layer. However, ultraviolet rays containing lights with wavelengths of 184.9 nm and 253.7 nm can be used suitably for the formation of the silicon oxide film. Moreover, the ultraviolet generating lamp 43 used in the ultraviolet treatment apparatus 41 is also particularly not limited. For example, as long as ultraviolet rays containing such wavelengths as described above can be generated, the lamp can be used suitably for the formation of the silicon oxide film.

By forming an oxide film having a desired film-thickness uniformly on the SOI layer surface by subjecting the SOI wafer to the ultraviolet irradiation treatment as described above, charge state on the SOI layer surface can be rapidly stabilized, and also the film-thickness of the formed silicon oxide film can be uniform in the wafer plane, and therefore, then in measuring a V_{G}-I_{D} characteristic in a hole side by contacting such a mercury probe as explained as follows, effect of dispersion of oxide-film thickness in the wafer plane is excluded and dispersion in measurement value is not caused, and therefore the electric characteristic can be measured high-precisely.

In this case, it is preferable that thickness of the oxide film formed on the SOI layer surface is 5 nm or less. When the oxide film formed on the SOI layer surface has a very thin thickness, 5 nm or less, electricity can be certainly passed through the oxide film by tunnel effect of the silicon oxide film having a thin thickness in sequentially measuring the V_{G}-I_{D} characteristic in a hole side. Therefore, the electric characteristic of an SOI wafer can be measured accurately. On the other hand, it is preferable that the thickness of the oxide film formed on the SOI layer surface is 0.1 nm or more, and thereby charge state on the SOI layer surface can be certainly stabilized.

Moreover, in the above case, the above-described ultraviolet irradiation treatment may be performed so that the atmosphere in the chamber 45 of the ultraviolet treatment apparatus 41 contains oxygen to the extent of forming the silicon oxide film on the SOI layer, and particularly it is preferable that the treatment is performed in an air or a 100% oxygen atmosphere.

That is, when an air is used as the atmosphere containing oxygen in subjecting the SOI wafer to the ultraviolet irradiation treatment, a special atmospheric gas is not required to be prepared, and therefore the ultraviolet irradiation treatment can be simply performed, for example, without supplying an atmospheric gas from the atmospheric-gas supply duct 44. In addition, in the case of subjecting the SOI wafer to the ultraviolet irradiation treatment in an air as described above, for uniformly forming, for example, the silicon oxide film of 5 nm or less on the SOI layer surface, it is sufficient that the ultraviolet irradiation treatment is performed for approximately 1-100 min. As a specific example, the silicon oxide film of approximately 3 nm can be formed uniformly on the SOI layer surface by irradiating the SOI wafer with ultraviolet rays in an air for approximately 60 min, and therefore charge state on the SOI layer surface can be stabilized in a much shorter time than that of a conventional method.

On the other hand, in the case of performing the ultraviolet irradiation treatment, for example, by supplying an atmospheric gas from the atmospheric-gas supply duct 44, it becomes possible to perform the ultraviolet irradiation treatment in an atmosphere having higher oxygen partial pressure than that of an air, and the SOI wafer can be easily subjected to the ultraviolet irradiation treatment in such a 100% oxygen atmosphere as described above. By subjecting the SOI wafer to the ultraviolet irradiation treatment in a 100% oxygen atmosphere, generation of ozone is promoted to form rapidly the silicon oxide film having a uniform film-thickness, and therefore the treatment time of the ultraviolet irradiation treatment can be more shortened. In the case of subjecting the SOI wafer to the ultraviolet irradiation treatment in such a 100% oxygen atmosphere, for forming, for example, the silicon oxide film of 5 nm or less on the SOI layer surface, it is sufficient that the ultraviolet irradiation treatment for approximately 1-50 min is performed. As a specific example, the silicon oxide film of approximately 3 nm can be formed uniformly on the SOI layer surface by irradiating the SOI wafer with ultraviolet rays in a 100% oxygen atmosphere for approximately 30 min, and therefore charge state on the SOI layer surface can be stabilized in a much shorter time.

After forming the oxide film having a desired film-thickness uniformly on the SOI layer surface as described above, a V_{G}-I_{D} characteristic in a hole side of the SOI wafer is measured by using a mercury probe apparatus 21 as shown in Fig. 3 (Step F in Fig. 12). For example, after the surface in the support wafer side of the SOI wafer W is sucked with a vacuum chuck 22, a mercury probe 23 is approximated to the very vicinity of the SOI layer surface of the SOI wafer W, and only the mercury electrode part is contacted with the SOI layer, and thereby a Pseudo-MOS structure is formed. Then, a constant drain voltage is applied from the mercury probe 23 and gate voltage is applied and changed in the negative side in the state, and at the same time, change of drain current is monitored, and thereby a V_{G}-I_{D} characteristic in a hole side can be measured, for example, as shown in Fig. 5.

By using mathematical formulas presented in the above-described Document No. 1 or 2, from gradients of the part A and the part B in the V_{G}-I_{D} characteristic in a hole side measured as Fig. 5, the hole mobility of the SOI layer in the SOI wafer and/or the charge density of the BOX layer therein can be obtained and evaluated (Step G in Fig. 12).

In particular, in the present invention, before measuring a V_{G}-I_{D} characteristic in a hole side of the SOI wafer as described above, charge state on the SOI layer surface is stabilized in a short time by forming the oxide film uniformly on the SOI layer surface by performing the ultraviolet irradiation treatment. Therefore, the measurement of a V_{G}-I_{D} characteristic in a hole side can be stably performed without causing dispersion in measurement value and the evaluation of a hole mobility of the SOI layer or a charge density of the BOX layer can be performed high-precisely in a short time.

In addition, the above-described measurement of a V_{G}-I_{D} characteristic in a hole side (Step F) and the evaluation of a hole mobility / a charge density (Step G) can be performed in approximately 2 hr by summing the two steps.

Moreover, in the present invention, for example, between the hydrofluoric acid cleaning treatment (Step B) and the measurement of a V_{G}-I_{D} characteristic in an electron side (Step C) in the flow chart shown in Fig. 12, the step (Step E) in which an oxide film is formed on the SOI layer surface by performing the ultraviolet irradiation treatment can be further added.

As described above, according to the method for evaluating an SOI wafer of the present invention, after removing a native oxide film on the SOI wafer surface by subjecting the SOI wafer to a hydrofluoric acid cleaning treatment, by forming newly, for example, an oxide film having a film thickness of 5 nm or less on the SOI layer surface by performing an ultraviolet irradiation treatment, charge state on the SOI layer surface can be rapidly stabilized to be a steady state, and then, the SOI wafer in which charge state on the SOI layer surface is stable is contacted with a mercury probe and a V_{G}-I_{D} characteristic is measured, and thereby an electric characteristic of the SOI wafer such as a hole mobility or a BOX layer charge density, or further, an electron mobility or an interface state density, can be evaluated high-precisely. Thereby, a large-scale apparatus and multiple steps such as a photolithography process are not required and evaluation of an SOI wafer can be very simply performed by using a mercury probe. Moreover, charge state on the SOI layer surface is very stable in measuring a V_{G}-I_{D} characteristic, and also a film thickness of the silicon oxide film formed by the ultraviolet irradiation treatment is uniform in the wafer plane. Therefore, highly reliable evaluation of an SOI wafer can be stably performed without causing dispersion in measurement value.

In particular, in the case of evaluating a hole mobility of the SOI wafer or a BOX layer charge density thereof, in a conventional method without being rested for 10-12 hr or more before measuring the V_{G}-I_{D} characteristic by a mercury probe, the charge state on the SOI layer surface is not stabilized and therefore the V_{G}-I_{D} characteristic cannot be measured accurately. However, according to the present invention, the charge state can be stabilized in a short time of approximately 100 min or less, particularly approximately 30-60 min or less by forming an oxide film on the SOI layer surface by an ultraviolet irradiation treatment. Therefore, according to the present invention, in particular, when a hole mobility or a BOX layer charge density is evaluated, the evaluation time of the SOI wafer can be drastically shortened as compared to that of a conventional method, and also operation rate of measurement apparatus can be improved, and therefore evaluation of an SOI wafer can be performed very effectively, and furthermore, administration of the SOI wafer in performing the evaluation also becomes much easier than that of a conventional method.

In addition, the method for evaluating an SOI wafer of the present invention is not limited to such steps as shown in the flow chart of Fig. 12, and modification or deletion of the steps can be appropriately performed according to the need or purpose.

For example, as described above, between the hydrofluoric acid cleaning treatment (Step B) and the measurement of a V_{G}-I_{D} characteristic in an electron side (Step C), the formation of an oxide film (Step E) in which an oxide film is formed on the SOI layer surface by performing the ultraviolet irradiation treatment can be added. Moreover, for example, as shown in Fig. 13, it is also possible that the formation of an oxide film by the ultraviolet irradiation treatment of Step E is performed immediately after the hydrofluoric acid cleaning treatment (Step B), and that then the evaluation of the SOI wafer can be performed by performing Steps C, D, F, and G, in order without performing the formation of an oxide film. As shown in Fig. 13, by forming the oxide film on the SOI layer surface by performing the ultraviolet irradiation treatment immediately after the hydrofluoric acid cleaning treatment, in measuring the V_{G}-I_{D} characteristic in an electron side or in measuring the V_{G}-I_{D} characteristic in a hole side, charge state on the SOI layer surface is stable, and also effect of an native oxide film in danger of being formed in the measurement can be certainly excluded, and the measurement can be stably performed without causing dispersion in measurement value. Therefore, it becomes possible that the evaluation of the electron mobility / the interface state density and the hole mobility /the charge density can be performed high-precisely.

Furthermore, in the present invention, in the case of performing, for example, only evaluation of an electron mobility of the SOI wafer and/or an interface state density thereof, it is possible, for example, that Steps A, B, E, C, D as shown in Fig. 13 are performed in order and that then the evaluation of the SOI wafer is finished. On the other hand, in the case of performing only evaluation of a hole mobility of the SOI wafer and/or a charge density of a BOX layer thereof, it is possible that Steps C and D in the flow chart shown in Fig. 12 are omitted and Steps E-G is performed immediately after performing Steps A and B. In this case, as described above, if the V_{G}-I_{D} characteristic in a hole side is measured immediately after the removal of the native oxide film, a long time is required until measurement value is stabilized. Therefore, it is necessary to perform the formation of an oxide film by the ultraviolet irradiation treatment of Step E.

Moreover, according to the need, it is possible that two SOI wafers produced under the same condition in Step A are prepared, and one SOI wafer is subjected to Steps B, E, C, and D, in order, and thereby the evaluation of an electron mobility and/or an interface state density is performed, and, the other SOI wafer is subjected to Steps B, E, F, and G, in order, and thereby the evaluation of a hole mobility and/or a charge density of the BOX layer is performed. When two SOI wafers are prepared and evaluated separately to each other, sweep of gate voltage is sufficient to be performed only in the positive side or the negative side. Therefore, the evaluation of an SOI wafer can be performed in a much shorter time, and also, stress applied to the SOI wafer can be reduced.

Furthermore, in the present invention, the evaluation of the SOI wafer may be performed by interchanging Steps C and D and Steps E-G in Fig. 12. That is, it is also possible that after the SOI wafer is prepared and subjected to the hydrofluoric acid cleaning treatment (Steps A and B), charge state on the SOI layer surface is rapidly stabilized by forming an oxide film on the SOI layer surface by performing the ultraviolet irradiation treatment, and then the evaluation of a hole mobility / a BOX layer charge density is performed by performing Steps F and G, and then the evaluation of an electron mobility / an interface state density is performed by performing Steps C and D.

That is, with respect to the present invention, it is sufficient that after the hydrofluoric acid cleaning treatment, the silicon oxide film can be formed on the SOI layer surface by performing the ultraviolet irradiation treatment before measuring the V_{G}-I_{D} characteristic, particularly before measuring the V_{G}-I_{D} characteristic in a hole side. And thereby, the charge state on the SOI layer surface can be stabilized in a short time, and therefore it is not necessary that the SOI wafer is stored for 10-12 hr or more before measuring the V_{G}-I_{D} characteristic as a conventional method, and the SOI wafer can be evaluated very effectively. Therefore, in the present invention, for example, there is no problem even when either the evaluation of a V_{G}-I_{D} characteristic in an electron side or the evaluation of a V_{G}-I_{D} characteristic in a hole side is first performed.

Fig. 15 is a flow chart showing further another example of the method for evaluating an SOI wafer according to the present invention. In addition, the flow chart shown in Fig. 15 shows a case that after performing a hydrofluoric acid cleaning treatment, the electron mobility / the interface state density is evaluated by measuring the V_{G}-I_{D} characteristic in an electron side of the SOI wafer, and then an oxide film is formed on the SOI layer surface, and the hole mobility / the charge density is evaluated by measuring the V_{G}-I_{D} characteristic in a hole side. However, the present invention is not limited thereto at all. As explained in detail as follows, formation of an oxide film by a second cleaning treatment of Step E may be performed between Step B and Step C, or only the evaluation of a hole mobility / an electron density may be performed by omitting Step C and Step D, and modification can be appropriately performed according to the purpose.

First, as shown in Fig. 15, an SOI wafer to be an evaluation object is prepared (Step A). The SOI wafer to be an object of the evaluation in the present invention is sufficient, for example, to have an SOI structure in which a buried oxide film to be an insulator layer and an SOI layer are formed above a support wafer. The production method thereof is not limited particularly. For example, as the SOI wafer to be prepared, there can be used an SOI wafer in which polished surfaces of two mirror-polished wafers on which a silicon oxide film is formed on at least one surface of silicon wafers are bonded to each other, and in which then one wafer of them is thinned by grinding and polishing after heat treatment (bonding method). Moreover, there can be used an SOI wafer in which one mirror-polished wafer preliminarily ion-implanted with hydrogen is bonded to another mirror-polished wafer in polished surfaces thereof, and then an SOI structure is formed by delaminating one wafer from the hydrogen-ion implanted layer by performing heat treatment, and then a surface of a thin film to be the SOI layer is polished (hydrogen ion delamination method). Furthermore, there can be also used a so-called SIMOX wafer produced by ion-implanting oxygen into one mirror-polished wafer and then performing a high-temperature heat treatment.

Next, by subjecting the prepared SOI wafer to a hydrofluoric acid cleaning treatment to be a first cleaning treatment by using an aqueous solution containing HF, a native oxide film formed on a surface of the SOI wafer is removed (Step B in Fig. 15). In general, in an SOI wafer, an oxide film having a thin film-thickness called as the native oxide film is formed on the wafer surface by contact with the atmospheric air or the like. The formation of the native oxide film is not uniform on the surface of the SOI wafer, and therefore dispersion in thickness of the oxide film is caused in the wafer plane. Even if such an SOI wafer on which a native oxide film is formed is evaluated as it is, accurate evaluation cannot be performed due to effect such as thickness dispersion of the native oxide film or impurities contained in the native oxide film. Therefore, first, by subjecting the prepared SOI wafer to the hydrofluoric acid cleaning treatment (first cleaning treatment), the native oxide film on the wafer surface is removed.

In the above case, HF concentration in an aqueous solution used in the hydrofluoric acid cleaning treatment is not particularly limited as long as an extent being capable of removing the native oxide film. However, it can be thought that if the HF concentration is too high, a BOX layer lying between the SOI layer and the support wafer also becomes etched. Therefore, it is preferable that the HF concentration is relatively low. For example, it is preferable that an aqueous solution having the HF concentration of 0.5% to 5%, particularly, approximately 1% is used. Also, a cleaning condition such as aqueous solution temperature or cleaning time in performing the hydrofluoric acid cleaning treatment is possible as long as an extent being capable of removing the native oxide film, and can be modified appropriately according to the need.

The SOI wafer subjected to the hydrofluoric acid cleaning treatment with an aqueous solution containing HF as described above is then, for example, rinse-treated by pure water in which dissolved oxygen is reduced as much as possible, and dried. In the rinse treatment, by using the pure water in which dissolved oxygen is reduced as much as possible as described above, it can be suppressed that a native oxide film is formed on the SOI wafer again. Moreover, with respect to the drying method, drying may be performed by blowing a dry air having a reduced moisture concentration to the SOI wafer or by using such an apparatus as a spin dryer. Or, the drying may be performed by using a chemical solution such as IPA.

With respect to the SOI wafer in which the native oxide film is removed by performing the hydrofluoric acid cleaning treatment as described above, the V_{G}-I_{D} characteristic in an electron side is immediately measured by using a mercury probe apparatus 21 as shown in Fig. 3 (Step C in Fig. 15). For example, the SOI wafer W is put in the apparatus so that the SOI layer thereof is downward namely so that the surface in the SOI layer side is put on a not-shown stage, and then the surface opposite to the surface put on the stage namely the surface in the support wafer side of the SOI wafer is sucked from above with a vacuum chuck 22. The vacuum chuck 22 is made of conductive material such as metal and doubles as a gate electrode.

After the surface in the support wafer side of the SOI wafer W is sucked with the vacuum chuck 22, the stage is moved apart from the SOI wafer W. Then, a mercury probe 23 is approximated to the very vicinity of the SOI layer surface of the SOI wafer W, and only the mercury electrode part is contacted with the SOI layer. In this case, the mercury probe 23 has a structure as shown in Fig. 4 and any one of mercury electrode parts 24, 25 is set to be a source electrode and the other thereof is set to be a drain electrode. In this way, for example, a Pseudo-MOS structure as shown in Fig. 8 can be formed.

A constant drain voltage is applied in the state in which a Pseudo-MOS structure is formed, and gate voltage is applied and changed in the positive side in the state, and at the same time, change of drain current is monitored, and thereby a relation between the gate voltage V_{G} and the drain current I_{D} in an electron side, namely, the V_{G}-I_{D} characteristic in an electron side, can be measured. The measured V_{G}-I_{D} characteristic in an electron side is, for example, displayed in Fig. 6.

By using, for example, mathematical formulas presented in the above-described Document No. 1 or 2, from gradients of the part C and the part D in the V_{G}-I_{D} characteristic in an electron side measured as Fig. 6, the electron mobility of the SOI layer in the SOI wafer and/or the interface state density between the SOI layer and the buried oxide film can be obtained and evaluated (Step D in Fig. 15). In this case, in the present invention, after removing the native oxide film, a V_{G}-I_{D} characteristic in an electron side of the SOI wafer can be immediately measured as described above. When the V_{G}-I_{D} characteristic in an electron side is measured immediately after the removal of the native oxide film as described above, the measurement data are relatively stable. Therefore, the electron mobility and/or the interface state density can be measured accurately.

In addition, the above-described measurement of a V_{G}-I_{D} characteristic in an electron side (Step C) and the evaluation of an electron mobility / an interface state density (Step D) can be performed in approximately 2 hr by summing the two steps.

Sequentially, after evaluating an electron mobility of the SOI wafer or an interface state density thereof as described above, a silicon oxide film is formed on the SOI layer surface of the SOI wafer by subjecting the SOI wafer to a second cleaning treatment by using a cleaning solution having a component being capable of forming a silicon oxide film (Step E in Fig. 15). By forming a silicon oxide film having a desired film-thickness uniformly on the SOI layer surface by subjecting the SOI wafer to the second cleaning treatment as described above, charge state on the SOI layer surface can be rapidly stabilized, and also the film thickness of the formed silicon oxide film can be uniform in the wafer plane, and therefore, then in measuring a V_{G}-I_{D} characteristic in a hole side by contacting such a mercury probe as explained as follows, effect of dispersion of oxide-film thickness in the wafer plane is excluded and dispersion in measurement value is not caused, and therefore the electric characteristic can be measured high-precisely.

In this case, it is preferable that thickness of the oxide film formed on the SOI layer surface is 5 nm or less. When the oxide film formed on the SOI layer surface has a very thin thickness, 5 nm or less, electricity can be certainly passed through the oxide film by tunnel effect of the silicon oxide film having a thin thickness in sequentially measuring the V_{G}-I_{D} characteristic in a hole side. Therefore, the electric characteristic of an SOI wafer can be measured accurately. On the other hand, it is preferable that the thickness of the oxide film formed on the SOI layer surface is 0.1 nm or more, and thereby charge state on the SOI layer surface can be certainly stabilized.

Moreover, a cleaning solution used in the second cleaning treatment is not particularly limited as long as having a component being capable of forming a silicon oxide film, and various aqueous solutions can be used. However, it is preferable that the cleaning solution is selected from, for example, ozone water, aqueous solution containing ammonium and hydrogen peroxide solution, hydrogen peroxide solution, aqueous solution containing hydrochloric acid and hydrogen peroxide solution, aqueous solution containing sulfuric acid and hydrogen peroxide solution, and highly oxidizing aqueous solution having high oxidation-reduction potential, and furthermore, it is preferable that as the highly oxidizing aqueous solution having high oxidation-reduction potential, electrolyzed anode water is used.

In an aqueous solution as presented above, a component being capable of forming rapidly a silicon oxide film on the SOI layer surface such as ozone or hydrogen peroxide or OH- ion contained in a highly oxidizing aqueous solution such as electrolyzed anode water, and therefore, by performing the second cleaning treatment by using an aqueous solution selected from the above as the cleaning solution, an oxide film having a uniform film-thickness can be very stably formed on the SOI layer surface at the same time as cleaning the wafer surface. In addition, with respect to composition of the cleaning solution used in the second cleaning treatment, any composition is possible as long as being capable of forming a silicon oxide film uniformly on the SOI layer surface of the SOI wafer, particularly, at a thickness of 5 nm or less.

For example, as the cleaning solution, the aqueous solution containing ammonium and hydrogen peroxide solution is selected and the SOI wafer is subjected to the second cleaning treatment, and thereby the SOI wafer becomes subjected to SC-1 cleaning, and therefore contamination such as particles adhering to the SOI layer surface can be removed, and also the silicon oxide film can be formed uniformly at a desired thickness on the SOI layer surface.

Moreover, as the cleaning solution, the aqueous solution containing hydrochloric acid and hydrogen peroxide solution is selected and the second cleaning treatment is performed, and thereby the SOI wafer becomes subjected to SC-2 cleaning, and therefore metal impurities adhering to the SOI layer surface can be removed, and also the silicon oxide film can be formed uniformly at a desired thickness on the SOI layer surface.

Moreover, as the cleaning solution, the aqueous solution containing sulfuric acid and hydrogen peroxide solution is selected and the second cleaning treatment is performed, and thereby organic impurities adhering to the SOI layer surface can be removed, and also the silicon oxide film can be formed uniformly at a desired thickness on the SOI layer surface.

Moreover, in the case that the highly oxidizing aqueous solution having high oxidation-reduction potential such as electrolyzed anode water is selected as the cleaning solution, it is preferable that the anode wafer is used so that pH thereof is approximately regulated to 2-6 and so that oxidation-reduction potential is approximately regulated to +300 to +1200 mV. By subjecting the SOI wafer to the second cleaning treatment with such an anode wafer, the uniform silicon oxide film having a desired film-thickness can be formed easily on the SOI layer surface of the wafer because OH- ions are contained in abundance in the cleaning solution.

Furthermore, the cleaning solution used in the second cleaning treatment is not limited to one kind. For example, in the second cleaning treatment, after performing the first of the second cleaning treatment by cleaning the SOI wafer with the aqueous solution containing ammonium and hydrogen peroxide solution, the second of the second cleaning treatment is performed by further cleaning the SOI wafer with the aqueous solution containing hydrochloric acid and hydrogen peroxide solution, and thereby a silicon oxide film having a extremely thin film-thickness of 5 nm or less and being uniform can be also formed on the SOI layer surface of the SOI wafer. In this case, it is sufficient that in each of the compositions of the aqueous solutions, the rate of hydrogen peroxide solution that is component for forming a silicon oxide film is made to be small or the cleaning time is shortened and thereby the uniform silicon oxide film is formed on the SOI layer surface so as to be an extremely thin film of the total of 5 nm or less by the above-described two second cleaning treatments.

Moreover, in performing the second cleaning treatment in such a manner, it is preferable that liquid temperature of the cleaning solution is room temperature to 80°C. When the liquid temperature of the cleaning solution is 80°C or less, the silicon oxide film-forming component such as ozone or hydrogen peroxide or OH⁻ ion contained in the cleaning solution is prevented from evaporating, and thereby a uniform silicon oxide film can be formed rapidly and certainly. On the other hand, if the liquid temperature is attempted to be lower than room temperature, equipment for cooling the cleaning solution is required additionally, and therefore it is thought that cost becomes large and the cleaning equipment comes to have a large scale. Therefore, it is suitable that the cleaning solution being at liquid temperature of room temperature or more is used because burden to cost can be reduced and thereby the second cleaning treatment can be performed simply.

In addition, in the case of performing the second cleaning treatment by using such a cleaning solution as described above, by performing, for example, the second cleaning treatment in a treatment time of approximately 30 min or less particularly approximately 1-10 min, the silicon oxide film of 5 nm or less can be formed uniformly on the SOI layer surface. As a specific example, by subjecting the SOI wafer to the second cleaning treatment for approximately 4 min by using, for example, a room-temperature ozone water in which 10-ppm ozone is dissolved, the silicon oxide film of approximately 3 nm can be formed uniformly on the SOI layer surface at the same time as cleaning the wafer surface, and therefore charge state on the SOI layer surface can be stabilized in a much shorter time than that of a conventional method.

The SOI wafer in which the oxide film having a desired film-thickness is formed uniformly on the SOI layer surface as described above is, for example, rinse-treated by pure water and dried, and then, a V_{G}-I_{D} characteristic in a hole side of the SOI wafer is measured by using a mercury probe apparatus 21 as shown in Fig. 3 (Step F in Fig. 15). For example, after the surface in the support wafer side of the SOI wafer W is sucked with a vacuum chuck 22, a mercury probe 23 is approximated to the very vicinity of the SOI layer surface of the SOI wafer W, and only the mercury electrode part is contacted with the SOI layer, and thereby a Pseudo-MOS structure is formed. Then, a constant drain voltage is applied from the mercury probe 23 and gate voltage is applied and changed in the negative side in the state, and at the same time, change of drain current is monitored, and thereby a V_{G}-I_{D} characteristic in a hole side can be measured, for example, as shown in Fig. 5.

Then, by using mathematical formulas presented in the above-described Document No. 1 or 2, from gradients of the part A and the part B in the V_{G}-I_{D} characteristic in a hole side measured as Fig. 5, the hole mobility of the SOI layer in the SOI wafer and/or the charge density of the BOX layer therein can be obtained and evaluated (Step G in Fig. 15).

In particular, in the present invention, before measuring a V_{G}-I_{D} characteristic in a hole side of the SOI wafer as described above, charge state on the SOI layer surface is stabilized in a short time by forming the oxide film uniformly on the SOI layer surface by performing the second cleaning treatment. Therefore, the measurement of a V_{G}-I_{D} characteristic in a hole side can be stably performed without causing dispersion in measurement value and the evaluation of a hole mobility of the SOI layer or a charge density of the BOX layer can be performed high-precisely in a short time.

In addition, the above-described measurement of a V_{G}-I_{D} characteristic in a hole side (Step F) and the evaluation of a hole mobility / a charge density (Step G) can be performed in approximately 2 hr by summing the two steps.

Moreover, in the present invention, for example, between the hydrofluoric acid cleaning treatment (Step B) and the measurement of a V_{G}-I_{D} characteristic in an electron side (Step C) in the flow chart shown in Fig. 15, a step of forming an oxide film on the SOI layer surface by performing the cleaning treatment by using a cleaning solution being capable of forming a silicon oxide film can be further added.

As described above, according to the method for evaluating an SOI wafer of the present invention, after removing a native oxide film on the SOI wafer surface by subjecting the SOI wafer to a hydrofluoric acid cleaning treatment, by forming newly, for example, an oxide film having a film thickness of 5 nm or less on the SOI layer surface by performing a second cleaning treatment, charge state on the SOI layer surface can be rapidly stabilized to be a steady state, and then the SOI wafer in which charge state on the SOI layer surface is stable is contacted with a mercury probe and a V_{G}-I_{D} characteristic is measured, and thereby an electric characteristic of the SOI wafer such as a hole mobility or a BOX layer charge density, or further, an electron mobility or an interface state density, can be evaluated high-precisely. Thereby, a large-scale apparatus and multiple steps such as a photolithography process are not required and evaluation of an SOI wafer can be very simply performed by using a mercury probe. Moreover, charge state on the SOI layer surface is very stable in measuring a V_{G}-I_{D} characteristic, and also a film thickness of the silicon oxide film formed by the second cleaning treatment is uniform in the wafer plane. Therefore, highly reliable evaluation of an SOI wafer can be stably performed without causing dispersion in measurement value.

In particular, in the case of evaluating a hole mobility of the SOI wafer or a BOX layer charge density thereof, in a conventional method without being rested for 10-12 hr or more before measuring the V_{G}-I_{D} characteristic by a mercury probe, the charge state on the SOI layer surface is not stabilized and therefore the V_{G}-I_{D} characteristic cannot be measured accurately. However, according to the present invention, the charge state can be stabilized in a very short time of approximately 30 min or less, particularly approximately 10 min or less by forming an oxide film on the SOI layer surface by a second cleaning treatment. Therefore, according to the present invention, in particular, when a hole mobility or a BOX layer charge density is evaluated, the evaluation time of the SOI wafer can be drastically shortened as compared to that of a conventional method, and also operation rate of measurement apparatus can be improved, and therefore evaluation of an SOI wafer can be performed very effectively, and furthermore administration of the SOI wafer in performing the evaluation also becomes much easier than that of a conventional method.

In addition, the method for evaluating an SOI wafer of the present invention is not limited to such steps as shown in the flow chart of Fig. 15, and modification or deletion of the steps can be appropriately performed according to the need or purpose.

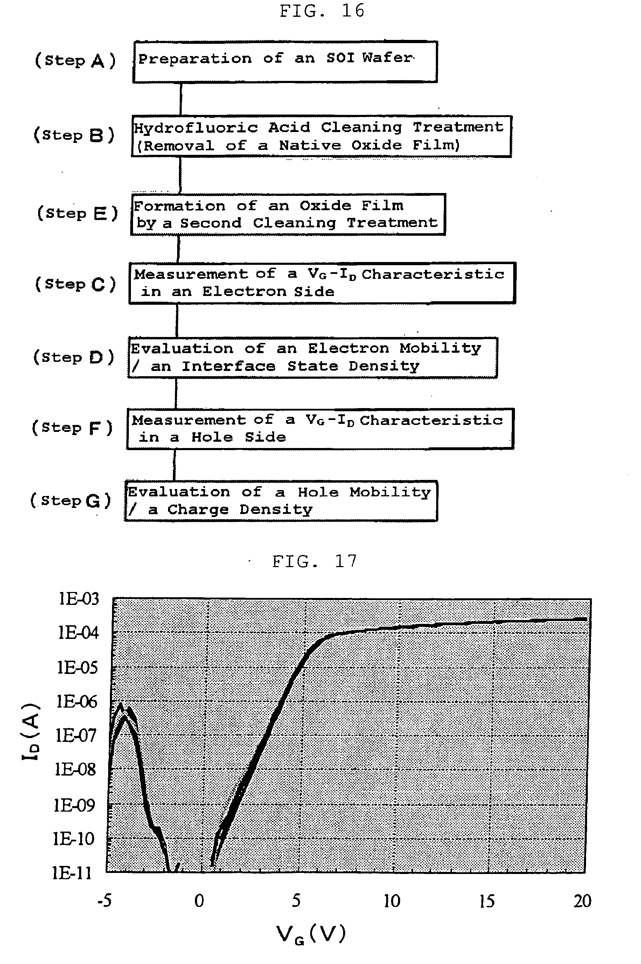

For example, as described above, between the hydrofluoric acid cleaning treatment (Step B) and the measurement of a V_{G}-I_{D} characteristic in an electron side (Step C), a step for forming an oxide film on the SOI layer surface by performing the cleaning treatment by using a cleaning solution being capable of forming a silicon oxide film can be further added. Moreover, for example, as shown in Fig. 16, it is also possible that the formation of an oxide film by the second cleaning treatment of Step E is performed immediately after the hydrofluoric acid cleaning treatment (Step B), and that then the evaluation of the SOI wafer can be performed by performing Steps C, D, F, and G, in order without performing the formation of an oxide film. As shown in Fig. 16, by forming the oxide film on the SOI layer surface by performing the second cleaning treatment immediately after the hydrofluoric acid cleaning treatment, in measuring the V_{G}-I_{D} characteristic in an electron side or in measuring the V_{G}-I_{D} characteristic in a hole side, charge state on the SOI layer surface is stable, and also effect of an native oxide film in danger of being formed in the measurement can be certainly excluded, and the measurement can be stably performed without causing dispersion in measurement value. Therefore, it becomes possible that the evaluation of the electron mobility / the interface state density and the hole mobility /the charge density can be performed high-precisely.

Furthermore, in the present invention, in the case of performing, for example, only evaluation of an electron mobility of the SOI wafer and/or an interface state density thereof, it is possible, for example, that Steps A, B, E, C, D as shown in Fig. 16 are performed in order and that then the evaluation of the SOI wafer is finished. On the other hand, in the case of performing only evaluation of a hole mobility of the SOI wafer and/or a charge density of a BOX layer thereof, it is possible that Steps C and D in the flow chart shown in Fig. 15 are omitted and Steps E-G is performed immediately after performing Steps A and B. In this case, as describe above, if the V_{G}-I_{D} characteristic in a hole side is measured immediately after the removal of the native oxide film, a long time is required until measurement value is stabilized. Therefore, it is necessary to perform the formation of an oxide film by the second cleaning treatment of Step E.

Moreover, according to the need, it is possible that two SOI wafers produced under the same condition in Step A are prepared, and one SOI wafer is subjected to Steps B, E, C, and D, in order, and thereby the evaluation of an electron mobility and/or an interface state density is performed, and the other SOI wafer is subjected to Steps B, E, F, and G, in order, and thereby the evaluation of a hole mobility and/or a charge density of the BOX layer is performed. When two SOI wafers are prepared and evaluated separately to each other, sweep of gate voltage is sufficient to be performed only in the positive side or the negative side. Therefore, the evaluation of an SOI wafer can be performed in a much shorter time, and also stress applied to the SOI wafer can be reduced.

Furthermore, in the present invention, the evaluation of the SOI wafer may be performed by interchanging Steps C and D and Steps E-G in Fig. 15. That is, it is also possible that after the SOI wafer is prepared and subjected to the hydrofluoric acid cleaning treatment (Steps A and B), charge state on the SOI layer surface is rapidly stabilized by forming an oxide film on the SOI layer surface by performing the second cleaning treatment, and then the evaluation of a hole mobility / a BOX layer charge density is performed by performing Steps F and G, and then the evaluation of an electron mobility / an interface state density is performed by performing Steps C and D.

That is, in the present invention, it is sufficient that after the hydrofluoric acid cleaning treatment, the silicon oxide film can be formed on the SOI layer surface by performing the second cleaning treatment before measuring the V_{G}-I_{D} characteristic, particularly before measuring the V_{G}-I_{D} characteristic in a hole side. And thereby, the charge state on the SOI layer surface can be stabilized in a short time, and therefore it is not necessary that the SOI wafer is stored for 10-12 hr or more before measuring the V_{G}-I_{D} characteristic as a conventional method, and the SOI wafer can be evaluated very effectively. Therefore, in the present invention, for example, there is no problem even when either the evaluation of a V_{G}-I_{D} characteristic in an electron side or the evaluation of a V_{G}-I_{D} characteristic in a hole side is first performed.

Hereinafter, the present invention will be explained more specifically with reference to Examples and Comparative examples. However the present invention is not limited thereto.

### (Example 1)

An SOI wafer to be the evaluation object was prepared by producing an SOI wafer by hydrogen ion delamination method by using silicon wafers having a conductivity type of p type and a 200-mm diameter and a <100> crystal orientation as the support wafer and the bond wafer to form the SOI layer (Step A in Fig. 1). In addition, as dopant for setting the conductivity type of the wafer to P type, boron was used. Moreover, thicknesses of the SOI layer of the produced SOI wafer and the BOX layer thereof were approximately 100 nm, 145 nm, respectively.

The prepared SOI wafer was subjected to a hydrofluoric acid cleaning treatment for 1 min by using an aqueous solution containing 1-wt% HF (Step B in Fig. 1). Then, after performing rinse by pure water, moisture was removed and dried by blowing a dry air to the SOI wafer.

Immediately after the drying, without performing a corona discharge treatment (Step C in Fig. 1) for loading a negative charge on the SOI layer surface, the SOI wafer was set to a mercury probe apparatus (CVmap92 manufactured by Four DIMENSIONS Inc.) and the measurement of a V_{G}-I_{D} characteristic in an electron side was performed (Step D in Fig. 1). The measurement result is shown in Fig. 17. In this case, the measurement of a V_{G}-I_{D} characteristic in an electron side can be performed by changing gate voltage in the state of applying a constant drain voltage from the drain electrode and by monitoring drain current at the same time. By using the measurement result of a V_{G}-I_{D} characteristic in an electron side as shown in Fig. 17 and mathematical formulas presented in the above-described Document No. 1 and 2, the electron mobility of the SOI layer and/or the interface state density between the SOI layer and the buried oxide film can be obtained and evaluated (Step E in Fig. 1). In this case, it was possible to be performed for approximately 2 hr from the initiation of the measurement of a V_{G}-I_{D} characteristic in an electron side to the obtaining of the electron mobility and the interface state density.

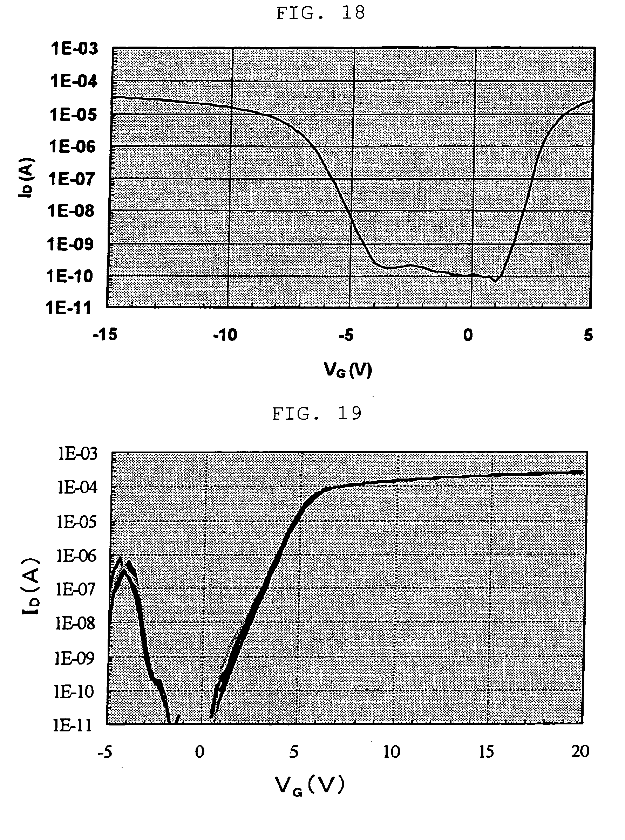

Sequentially, by using KG101 manufactured by SEMILAB Inc. as the corona charge apparatus, the SOI wafer was subjected to the corona discharge treatment for 10 min, and thereby a positive charge was loaded on the SOI layer surface of the SOI wafer at a charge amount of 3000 nC/cm² (Step F in Fig. 1). Then, the SOI wafer was immediately set to the mercury probe apparatus (CVmap92 manufactured by Four DIMENSIONS Inc.) and the measurement of a V_{G}-I_{D} characteristic in a hole side was performed (Step G in Fig. 1). The measurement result is shown in Fig. 18. By using the measurement result of a V_{G}-I_{D} characteristic in a hole side as shown in Fig. 18 and mathematical formulas presented in the above-described Document No. 1 and 2, the hole mobility of the SOI layer and/or the charge density of the BOX layer can be obtained and evaluated (Step H in Fig. 1). In this case, it was possible to be performed for approximately 2 hr from the initiation of the measurement of a V_{G}-I_{D} characteristic in a hole side to the obtaining of the hole mobility of the SOI layer and the charge density of the BOX layer.

Accordingly, in the evaluation of an SOI wafer performed in Example 1, it was possible that the electron mobility, the interface state density, the hole mobility, and the BOX layer charge density, were evaluated for a short time, approximately 4 hr, from the subjecting the SOI wafer to the hydrofluoric acid cleaning treatment.

### (Example 2)

An SOI wafer to be the evaluation object was prepared by producing an SOI wafer by hydrogen ion delamination method by using silicon wafers having a conductivity type of P type and a 200-mm diameter and a <100> crystal orientation as the support wafer and the bond wafer to form the SOI layer (Step A in Fig. 9). In addition, as dopant for setting the conductivity type of the wafer to P type, boron was used. Moreover, thicknesses of the SOI layer of the produced SOI wafer and the BOX layer thereof were approximately 100 nm, 145 nm, respectively.

The prepared SOI wafer was subjected to a hydrofluoric acid cleaning treatment for 1 min by using an aqueous solution containing 1-wt% HF (Step B in Fig. 9). Then, after performing rinse by pure water in which dissolved oxygen was reduced as much as possible, moisture was removed and dried by blowing a dry air to the SOI wafer.

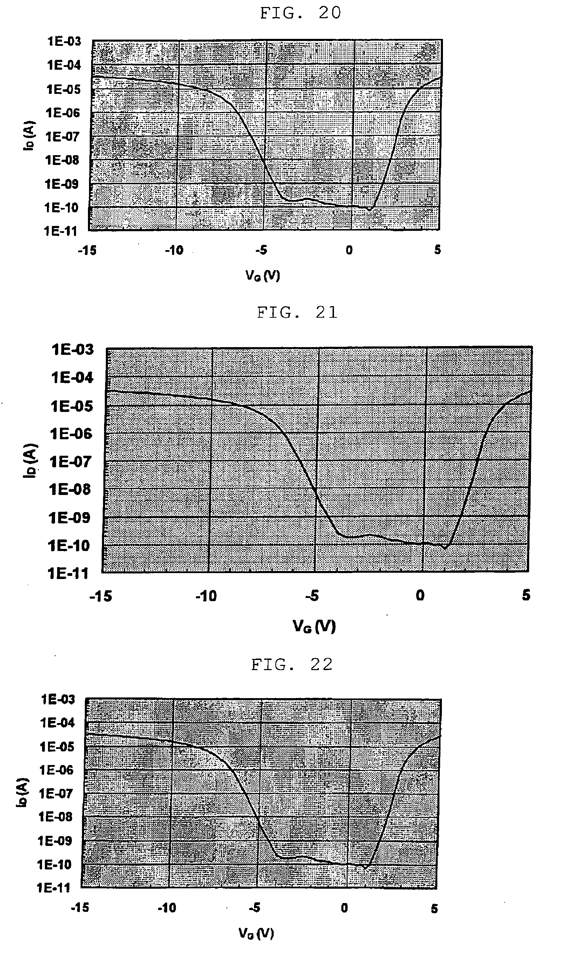

Immediately after the drying, the SOI wafer was set to the mercury probe apparatus and the measurement of a V_{G}-I_{D} characteristic in an electron side was performed (Step C in Fig. 9). The measurement result is shown in Fig. 19. In this case, the measurement of a V_{G}-I_{D} characteristic in an electron side can be performed by changing gate voltage in the state of applying a constant drain voltage from the drain electrode and by monitoring drain current at the same time. By using the measurement result of a V_{G}-I_{D} characteristic in an electron side as shown in Fig. 19 and mathematical formulas presented in the above-described Document No. 1 and 2, the electron mobility of the SOI layer and/or the interface state density between the SOI layer and the buried oxide film can be obtained and evaluated (Step D in Fig. 9). In this case, it was possible to be performed for approximately 2 hr from the initiation of the measurement of a V_{G}-I_{D} characteristic in an electron side to the obtaining of the electron mobility and the interface state density.

Sequentially, the SOI wafer was put on the metal plate 32 of the hot plate 31 as shown in Fig. 11, and the SOI wafer W was heated with the heater 33 and thereby heat treatment in an air at 210°C for 10 min was performed. And, thereby an oxide film of approximately 3 nm was formed on the SOI layer surface (Step E in Fig. 9). Then, immediately, the SOI wafer was set to the mercury probe apparatus, and the measurement of a V_{G}-I_{D} characteristic in a hole side was performed (Step F in Fig. 9). The measurement result is shown in Fig. 20. By using the measurement result of a V_{G}-I_{D} characteristic in a hole side as shown in Fig. 20 and mathematical formulas presented in the above-described Document No. 1 and 2, the hole mobility of the SOI layer and/or the charge density of the BOX layer can be obtained and evaluated (Step G in Fig. 9). In this case, it was possible to be performed for approximately 2 hr from the initiation of the measurement of a V_{G}-I_{D} characteristic in a hole side to the obtaining of the hole mobility of the SOI layer and the charge density of the BOX layer.

Accordingly, in the evaluation of an SOI wafer performed in Example 2, it was possible that the electron mobility, the interface state density, the hole mobility, and the BOX layer charge density, were evaluated for a short time, approximately 4 hr, from the subjecting the SOI wafer to the hydrofluoric acid cleaning treatment.

### (Example 3)

The same SOI wafer as Example 2 was prepared (Step A in Fig. 12), and from the hydrofluoric acid cleaning treatment (Step B in Fig. 12) to the measurement of a V_{G}-I_{D} characteristic in an electron side (Step C in Fig. 12) were performed under the same condition as Example 2. As a result, the V_{G}-I_{D} characteristic in an electron side as shown in Fig. 19 that was the same as the above Example 2 was obtained. From the measurement result of the V_{G}-I_{D} characteristic in an electron side as shown in Fig. 19, the electron mobility of the SOI layer and/or the interface state density between the SOI layer and the buried oxide film can be obtained and evaluated in the same manner as Example 2 (Step D in Fig. 12). In this case, it was possible to be performed for approximately 2 hr from the initiation of the measurement of a V_{G}-I_{D} characteristic in an electron side to the obtaining of the electron mobility and the interface state density.

Sequentially, the SOI wafer was put on the stage 42 of the ultraviolet treatment apparatus 41 as shown in Fig. 14, and a mercury lamp of 10 W was used as the ultraviolet generating lamp 43, and thereby the SOI wafer W was irradiated in an air for 60 min with ultraviolet rays containing lights of wavelengths of 184.9 nm and 253.7 nm. Thereby, a silicon oxide film of approximately 3 nm was formed on the SOI layer surface (Step E in Fig. 12). Then, immediately, the SOI wafer was set to the mercury probe apparatus, and the measurement of a V_{G}-I_{D} characteristic in a hole side was performed (Step F in Fig. 12). The measurement result is shown in Fig. 21. By using the measurement result of a V_{G}-I_{D} characteristic in a hole side as shown in Fig. 21 and mathematical formulas presented in the above-described Document No. 1 and 2, the hole mobility of the SOI layer and/or the charge density of the BOX layer can be obtained and evaluated (Step G in Fig. 12). In this case, it was possible to be performed for approximately 2 hr from the initiation of the measurement of a V_{G}-I_{D} characteristic in a hole side to the obtaining of the hole mobility of the SOI layer and the charge density of the BOX layer.

Accordingly, in the evaluation of an SOI wafer performed in Example 3, it was possible that the electron mobility, the interface state density, the hole mobility, and the BOX layer charge density, were evaluated for a short time, approximately 5 hr, from the subjecting the SOI wafer to the hydrofluoric acid cleaning treatment.

### (Example 4)

The same SOI wafer as Example 2 was prepared (Step A in Fig. 15), and from the hydrofluoric acid cleaning treatment (Step B in Fig. 15) to the measurement of a V_{G}-I_{D} characteristic in an electron side (Step C in Fig. 15) were performed under the same condition as Example 2. As a result, the V_{G}-I_{D} characteristic in an electron side as shown in Fig. 19 that was the same as the above Example 2 was obtained. From the measurement result of the V_{G}-I_{D} characteristic in an electron side as shown in Fig. 19, the electron mobility of the SOI layer and/or the interface state density between the SOI layer and the buried oxide film can be obtained and evaluated in the same manner as above Example 2 (Step D in Fig. 15). In this case, it was possible to be performed for approximately 2 hr from the initiation of the measurement of a V_{G}-I_{D} characteristic in an electron side to the obtaining of the electron mobility and the interface state density.

Sequentially, room-temperature ozone water in which 10-ppm ozone was dissolved in pure water by an ozone generation apparatus was used as the cleaning solution, and the SOI wafer was subjected to the second cleaning treatment for 4 min, and furthermore rinse was performed by pure water, and then moisture was removed and dried by blowing a dry air to the SOI wafer. Thereby, a silicon oxide film of approximately 3 nm was formed on the SOI layer surface (Step E in Fig. 15). Then, immediately, the SOI wafer was set to the mercury probe apparatus, and the measurement of a V_{G}-I_{D} characteristic in a hole side was performed (Step F in Fig. 15). The measurement result is shown in Fig. 22. By using the measurement result of a V_{G}-I_{D} characteristic in a hole side as shown in Fig. 22 and mathematical formulas presented in the above-described Document No. 1 and 2, the hole mobility of the SOI layer and/or the charge density of the BOX layer can be obtained and evaluated (Step G in Fig. 15). In this case, it was possible to be performed for approximately 2 hr from the initiation of the measurement of a V_{G}-I_{D} characteristic in a hole side to the obtaining of the hole mobility of the SOI layer and the charge density of the BOX layer.

### (Example 5)

The same SOI wafer as Example 2 was prepared (Step A in Fig. 15), and from the hydrofluoric acid cleaning treatment (Step B in Fig. 15) to the measurement of a V_{G}-I_{D} characteristic in an electron side (Step C in Fig. 15) were performed under the same condition as Example 2. As a result, the V_{G}-I_{D} characteristic in an electron side as shown in Fig. 19 that was the same as the above Example 2 was obtained. From the measurement result of the V_{G}-I_{D} characteristic in an electron side as shown in Fig. 19, the electron mobility of the SOI layer and/or the interface state density between the SOI layer and the buried oxide film can be obtained and evaluated in the same manner as Example 2 (Step D in Fig. 15). In this case, it was possible to be performed for approximately 2 hr from the initiation of the measurement of a V_{G}-I_{D} characteristic in an electron side to the obtaining of the electron mobility and the interface state density.

Sequentially, an aqueous solution in which the weight ratio of ammonium: hydrogen peroxide solution: pure water was 1:1:10 was used as the cleaning solution, and the SOI wafer was subjected to the second cleaning treatment for 4 min in the cleaning solution of which liquid temperature was held to 80°C, and furthermore the SOI wafer was rinsed by pure water and then dried by blowing a dry air thereto. Thereby, a silicon oxide film having a thickness of approximately 3 nm was formed on the SOI layer surface (Step E in Fig. 15). Then, immediately, the SOI wafer was set to the mercury probe apparatus, and the measurement of a V_{G}-I_{D} characteristic in a hole side was performed (Step F in Fig. 15). As a result, a V_{G}-I_{D} characteristic in a hole side as shown in Fig. 22 that was the same as the above Example 4 was obtained. From the measurement result of a V_{G}-I_{D} characteristic in a hole side as shown in Fig. 22, the hole mobility of the SOI layer and/or the charge density of the BOX layer can be obtained and evaluated in the same manner as the above Example 4 (Step G in Fig. 15). In this case, it was possible to be performed for approximately 2 hr from the initiation of the measurement of a V_{G}-I_{D} characteristic in a hole side to the obtaining of the hole mobility of the SOI layer and the charge density of the BOX layer.

### (Example 6)

The same SOI wafer as Example 2 was prepared (Step A in Fig. 15), and from the hydrofluoric acid cleaning treatment (Step B in Fig. 15) to the measurement of a V_{G}-I_{D} characteristic in an electron side (Step C in Fig. 15) were performed under the same condition as Example 2. As a result, the V_{G}-I_{D} characteristic in an electron side as shown in Fig. 19 that was the same as the above Example 2 was obtained. From the measurement result of the V_{G}-I_{D} characteristic in an electron side as shown in Fig. 19, the electron mobility of the SOI layer and/or the interface state density between the SOI layer and the buried oxide film can be obtained and evaluated in the same manner as Example 2 (Step D in Fig. 15). In this case, it was possible to be performed for approximately 2 hr from the initiation of the measurement of a V_{G}-I_{D} characteristic in an electron side to the obtaining of the electron mobility and the interface state density.

Sequentially, an aqueous solution in which the weight ratio of hydrogen peroxide solution: pure water was 1:10 (a diluted hydrogen peroxide solution) was used as the cleaning solution, and the SOI wafer was subjected to the second cleaning treatment for 3 min in the cleaning solution of which liquid temperature was held to 80°C, and furthermore the SOI wafer was rinsed by pure water and then dried by blowing a dry air thereto. Thereby, a silicon oxide film having a thickness of approximately 3 nm was formed on the SOI layer surface (Step E in Fig. 15). Then, immediately, the V_{G}-I_{D} characteristic in a hole side was measured in the same manner as Example 4 (Step F in Fig. 15) . As a result, a V_{G}-I_{D} characteristic in a hole side as shown in Fig. 22 that was the same as the above Example 4 was obtained. From the measurement result of a V_{G}-I_{D} characteristic in a hole side as shown in Fig. 22, the hole mobility of the SOI layer and/or the charge density of the BOX layer can be obtained and evaluated in the same manner as described above (Step G in Fig. 15). In this case, it was possible to be performed for approximately 2 hr from the initiation of the measurement of a V_{G}-I_{D} characteristic in a hole side to the obtaining of the hole mobility of the SOI layer and the charge density of the BOX layer.

### (Example 7)

The same SOI wafer as Example 2 was prepared (Step A in Fig. 15), and from the hydrofluoric acid cleaning treatment (Step B in Fig. 15) to the measurement of a V_{G}-I_{D} characteristic in an electron side (Step C in Fig. 15) were performed under the same condition as Example 2. As a result, the V_{G}-I_{D} characteristic in an electron side as shown in Fig. 19 that was the same as the above Example 2 was obtained. From the measurement result of the V_{G}-I_{D} characteristic in an electron side as shown in Fig. 19, the electron mobility of the SOI layer and/or the interface state density between the SOI layer and the buried oxide film can be obtained and evaluated in the same manner as Example 2 (Step D in Fig. 15). In this case, it was possible to be performed for approximately 2 hr from the initiation of the measurement of a V_{G}-I_{D} characteristic in an electron side to the obtaining of the electron mobility and the interface state density.

Sequentially, an aqueous solution in which the weight ratio of hydrochloric acid: hydrogen peroxide solution: pure water was 1:1:20 was used as the cleaning solution, and the SOI wafer was subjected to the second cleaning treatment for 4 min in the cleaning solution of which liquid temperature was held to 80°C, and furthermore the SOI wafer was rinsed by pure water and then dried by blowing a dry air thereto. Thereby, a silicon oxide film having a thickness of approximately 3 nm was formed on the SOI layer surface (Step E in Fig. 15). Then, immediately, the V_{G}-I_{D} characteristic in a hole side was measured in the same manner as Example 4 (Step F in Fig. 15). As a result, a V_{G}-I_{D} characteristic in a hole side as shown in Fig. 22 that was the same as the above Example 4 was obtained. From the measurement result of a V_{G}-I_{D} characteristic in a hole side as shown in Fig. 22, the hole mobility of the SOI layer and/or the charge density of the BOX layer can be obtained and evaluated in the same manner as described above (Step G in Fig. 15). In this case, it was possible to be performed for approximately 2 hr from the initiation of the measurement of a V_{G}-I_{D} characteristic in a hole side to the obtaining of the hole mobility of the SOI layer and the charge density of the BOX layer.

### (Example 8)

The same SOI wafer as Example 2 was prepared (Step A in Fig. 15), and from the hydrofluoric acid cleaning treatment (Step B in Fig. 15) to the measurement of a V_{G}-I_{D} characteristic in an electron side (Step C in Fig. 15) were performed under the same condition as Example 2. As a result, the V_{G}-I_{D} characteristic in an electron side as shown in Fig. 19 that was the same as the above Example 2 was obtained. From the measurement result of the V_{G}-I_{D} characteristic in an electron side as shown in Fig. 19, the electron mobility of the SOI layer and/or the interface state density between the SOI layer and the buried oxide film can be obtained and evaluated in the same manner as Example 2 (Step D in Fig. 15). In this case, it was possible to be performed for approximately 2 hr from the initiation of the measurement of a V_{G}-I_{D} characteristic in an electron side to the obtaining of the electron mobility and the interface state density.

Sequentially, an aqueous solution in which the weight ratio of sulfuric acid: hydrogen peroxide solution: pure water was 1:1:20 was used as the cleaning solution, and the SOI wafer was subjected to the second cleaning treatment for 4 min in the cleaning solution of which liquid temperature was held to room temperature, and furthermore the SOI wafer was rinsed by pure water and then dried by blowing a dry air thereto. Thereby, a silicon oxide film having a thickness of approximately 3 nm was formed on the SOI layer surface (Step E in Fig. 15). Then, immediately, the V_{G}-I_{D} characteristic in a hole side was measured in the same manner as Example 4 (Step F in Fig. 15). As a result, a V_{G}-I_{D} characteristic in a hole side as shown in Fig. 22 that was the same as the above Example 4 was obtained. From the measurement result of a V_{G}-I_{D} characteristic in a hole side as shown in Fig. 22, the hole mobility of the SOI layer and/or the charge density of the BOX layer can be obtained and evaluated in the same manner as described above (Step G in Fig. 15). In this case, it was possible to be performed for approximately 2 hr from the initiation of the measurement of a V_{G}-I_{D} characteristic in a hole side to the obtaining of the hole mobility of the SOI layer and the charge density of the BOX layer.

### (Example 9)

The same SOI wafer as Example 2 was prepared (Step A in Fig. 15), and from the hydrofluoric acid cleaning treatment (Step B in Fig. 15) to the measurement of a V_{G}-I_{D} characteristic in an electron side (Step C in Fig. 15) were performed under the same condition as Example 2. As a result, the V_{G}-I_{D} characteristic in an electron side as shown in Fig. 19 that was the same as the above Example 2 was obtained. From the measurement result of the V_{G}-I_{D} characteristic in an electron side as shown in Fig. 19, the electron mobility of the SOI layer and/or the interface state density between the SOI layer and the buried oxide film can be obtained and evaluated in the same manner as Example 2 (Step D in Fig. 15). In this case, it was possible to be performed for approximately 2 hr from the initiation of the measurement of a V_{G}-I_{D} characteristic in an electron side to the obtaining of the electron mobility and the interface state density.

Sequentially, anode water containing OH⁻ ion was produced by electrolyzing pure water, and the anode water of which pH was regulated to 4 and oxidation-reduction potential to 700 mV was used as the cleaning solution, and the SOI wafer was subjected to the second cleaning treatment for 10 min in the cleaning solution of which liquid temperature was held to room temperature, and furthermore the SOI wafer was rinsed by pure water and then dried by blowing a dry air thereto. Thereby, a silicon oxide film having a thickness of approximately 3 nm was formed on the SOI layer surface (Step E in Fig. 15). Then, immediately, the V_{G}-I_{D} characteristic in a hole side was measured in the same manner as Example 4 (Step F in Fig. 15). As a result, a V_{G}-I_{D} characteristic in a hole side as shown in Fig. 22 that was the same as the above Example 4 was obtained. From the measurement result of a V_{G}-I_{D} characteristic in a hole side as shown in Fig. 22, the hole mobility of the SOI layer and/or the charge density of the BOX layer can be obtained and evaluated in the same manner as described above (Step G in Fig. 15). In this case, it was possible to be performed for approximately 2 hr from the initiation of the measurement of a V_{G}-I_{D} characteristic in a hole side to the obtaining of the hole mobility of the SOI layer and the charge density of the BOX layer.

### (Example 10)

The same SOI wafer as Example 2 was prepared (Step A in Fig. 15), and from the hydrofluoric acid cleaning treatment (Step B in Fig. 15) to the measurement of a V_{G}-I_{D} characteristic in an electron side (Step C in Fig. 15) were performed under the same condition as Example 2. As a result, the V_{G}-I_{D} characteristic in an electron side as shown in Fig. 19 that was the same as the above Example 2 was obtained. From the measurement result of the V_{G}-I_{D} characteristic in an electron side as shown in Fig. 19, the electron mobility of the SOI layer and/or the interface state density between the SOI layer and the buried oxide film can be obtained and evaluated in the same manner as Example 2 (Step D in Fig. 15). In this case, it was possible to be performed for approximately 2 hr from the initiation of the measurement of a V_{G}- I_{D} characteristic in an electron side to the obtaining of the electron mobility and the interface state density.

Sequentially, the SOI wafer was subjected to the second cleaning treatment divided into two times. First, as the first of the second cleaning treatment, an aqueous solution in which the weight ratio of ammonium: hydrogen peroxide solution: pure water was 1:1:10 was used as the cleaning solution, and the SOI wafer was subjected to the cleaning treatment for 2 min in the cleaning solution of which liquid temperature was held to 80°C, and furthermore the SOI wafer was rinsed by pure water. Next, as the second of the second cleaning treatment, an aqueous solution in which the weight ratio of hydrochloric acid: hydrogen peroxide solution: pure water was 1:1:20 was used as the cleaning solution, and the SOI wafer was subjected to the cleaning treatment for 2 min in the cleaning solution of which liquid temperature was held to 80°C, and furthermore the SOI wafer was rinsed by pure water and then dried by blowing a dry air thereto. Thereby, a silicon oxide film having a thickness of approximately 3 nm was formed on the SOI layer surface (Step E in Fig. 15).

Then, immediately, the V_{G}-I_{D} characteristic in a hole side was measured in the same manner as Example 4 (Step F in Fig. 15). As a result, a V_{G}-I_{D} characteristic in a hole side as shown in Fig. 22 that was the same as the above Example 4 was obtained. From the measurement result of a V_{G}-I_{D} characteristic in a hole side as shown in Fig. 22, the hole mobility of the SOI layer and/or the charge density of the BOX layer can be obtained and evaluated in the same manner as described above (Step G in Fig. 15). In this case, it was possible to be performed for approximately 2 hr from the initiation of the measurement of a VG-I_{D} characteristic in a hole side to the obtaining of the hole mobility of the SOI layer and the charge density of the BOX layer.

As indicated as described above, in any one case of the evaluations of SOI wafers performed in Examples 4-10, it was possible that the electron mobility, the interface state density, the hole mobility, and the BOX layer charge density, were evaluated in a short time, approximately 4 hr from the subjecting the SOI wafer to the hydrofluoric acid cleaning treatment.

### (Comparative example 1)

As Comparative example 1, an SOI wafer produced under the same condition as Example 1 was prepared. The SOI wafer was subjected to the hydrofluoric acid cleaning treatment for 1 min with an aqueous solution containing 1-wt% HF, and then rinsed by pure water, and then moisture was removed and dried by blowing a dry air to the SOI wafer.

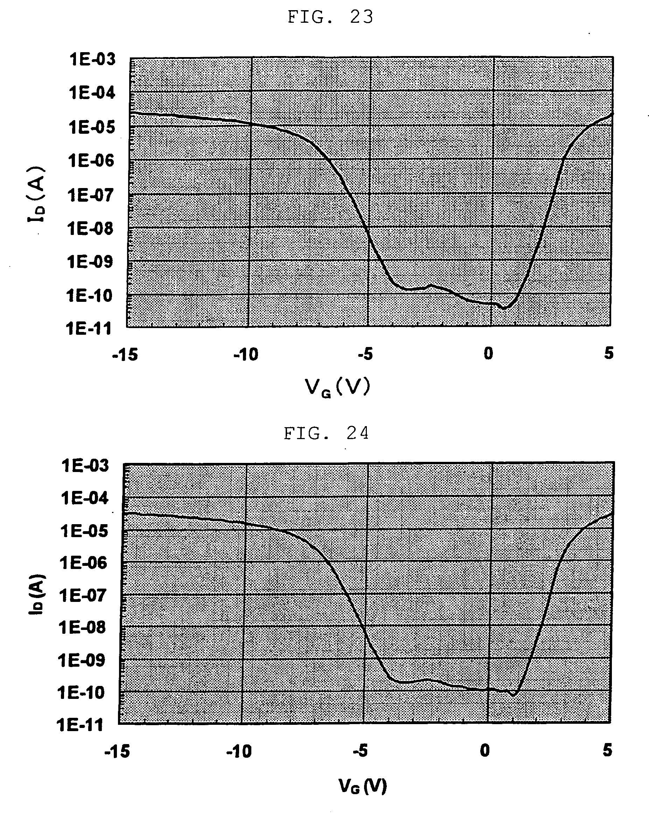

Immediately after drying the SOI wafer, the SOI wafer was set to the mercury probe apparatus and the measurement of a V_{G}-I_{D} characteristic in a hole side was performed without loading a negative charge on the SOI layer by the corona discharge treatment and measuring the V_{G}-I_{D} characteristic in an electron side and evaluating the electron mobility / the interface state density, and further without loading a positive charge on the SOI layer by the corona discharge treatment, and also without forming an oxide film on the SOI layer surface by the ultraviolet irradiation treatment or by the second cleaning treatment. The measurement result is shown in Fig. 23. When the measurement result as shown in Fig. 23 was compared with the V_{G}-I_{D} characteristic in a hole side as shown in Fig. 18 measured in Example 1, it was found that I_{D} with respect to V_{G} was globally lower. It is thought that this was generated because immediately after the removal of a native oxide film of the SOI wafer, the V_{G}-I_{D} characteristic in a hole side was measured without stabilizing charge state on the SOI layer surface of the SOI wafer.

### (Comparative example 2)

As Comparative example 2, an SOI wafer produced under the same condition as Example 1 was prepared. The SOI wafer was subjected to the hydrofluoric acid cleaning treatment for 1 min with an aqueous solution containing 1-wt% HF in the same manner as Example 1, and then rinsed by pure water, and then moisture was removed and dried by blowing a dry air to the SOI wafer.

Next, after exposing the SOI wafer to an air for 12 hr, the SOI wafer was set to the mercury probe apparatus and the measurement of a V_{G}-I_{D} characteristic in a hole side was performed without loading a negative charge on the SOI layer by the corona discharge treatment and measuring the V_{G}-I_{D} characteristic in an electron side and evaluating the electron mobility / the interface state density, and further without loading a positive charge on the SOI layer by the corona discharge treatment, and also without forming an oxide film on the SOI layer surface by the ultraviolet irradiation treatment or by the second cleaning treatment. The measurement result is shown in Fig. 24. From the measurement result of Fig. 24, the hole mobility of the SOI layer and the charge density of the BOX layer were obtained and evaluated. In this case, it was possible to be performed for approximately 1 hr from the initiation of the measurement of a V_{G}-I_{D} characteristic in a hole side to the obtaining of the hole mobility of the SOI layer and the charge density of the BOX layer.

Moreover, it was found that the measure result as shown in Fig. 24 was almost the same as the V_{G}-I_{D} characteristic in a hole side (Fig. 18) measured in Example 1. However, in Comparative example 2, although the electron mobility and the interface state density were not evaluated, 13 hr or more was required from when the SOI wafer was subjected to the hydrofluoric acid cleaning treatment until the hole mobility and the charge density were obtained. Therefore, approximately triple evaluation time was required more than that of the above-described Example.

From the above result, it was confirmed that in evaluating an SOI wafer, charge state on the SOI layer surface can be stabilized in a short time by subjecting the native oxide film-removed SOI wafer to a treatment for stabilizing charge state such as the corona discharge treatment or the new formation of a silicon oxide film on the SOI layer surface by performing the ultraviolet irradiation treatment or the second cleaning treatment, and therefore the time required for the evaluation of an SOI wafer, particularly, the time required from the performing the hydrofluoric acid cleaning treatment to the measurement of a V_{G}-I_{D} characteristic in a hole side can be certainly shortened. In addition, disturbance factors such as contamination of the wafer in such a case as exposing the wafer for 12 hr or more are few, and also reliability of data is high.

The present invention is not limited to the above-described embodiments. The above-described embodiments are mere examples, and those having the substantially same constitution as that described in the appended claims and providing the similar action and advantages are included in the scope of the present invention.

## Claims

1. A method for evaluating an SOI wafer by using a mercury probe, comprising at least steps of, subjecting the SOI wafer to a hydrofluoric acid cleaning treatment and thereby to remove a native oxide film formed in a surface of the SOI wafer, next subjecting the native oxide film-removed SOI wafer to a treatment for stabilizing charge state, then contacting the charge-state stabilizing-treated SOI wafer with the mercury probe, and thereby evaluating the SOI wafer.

2. The method for evaluating an SOI wafer according to Claim 1, wherein the treatment for stabilizing charge state is performed by loading a charge on an SOI layer surface of the SOI wafer by performing a corona discharge treatment or performed by forming an oxide film on an SOI layer surface of the SOI wafer.

3. The method for evaluating an SOI wafer according to Claim 2, wherein the charge loaded on a SOI layer surface of the SOI wafer by a corona discharge treatment is a positive charge.

4. The method for evaluating an SOI wafer according to Claim 2 or 3, wherein amount of the charge loaded on the SOI layer surface by a corona discharge treatment is 500 nC/cm² to 50000 nC/cm².

5. The method for evaluating an SOI wafer according to Claim 2, wherein thickness of the oxide film formed on the SOI layer surface is 5 nm or less.

6. The method for evaluating an SOI wafer according to Claim 2 or 5, wherein the formation of an oxide film on the SOI layer surface is performed by subjecting the SOI wafer to a heat treatment, an ultraviolet irradiation treatment, or a second cleaning treatment by using a cleaning solution being capable of forming a silicon oxide film.

7. The method for evaluating an SOI wafer according to Claim 6, wherein the heat treatment of the SOI wafer or the ultraviolet irradiation treatment thereof is performed in an atmosphere containing oxygen.

8. The method for evaluating an SOI wafer according to Claim 7, wherein the atmosphere containing oxygen is an air or a 100% oxygen atmosphere.

9. The method for evaluating an SOI wafer according to any one of Claims 6 to 8, wherein the heat treatment of the SOI wafer is performed at temperature of 50°C to 350°C.

10. The method for evaluating an SOI wafer according to Claim 6, wherein the cleaning solution being capable of forming a silicon oxide film is selected from, ozone water, aqueous solution containing ammonium and hydrogen peroxide solution, hydrogen peroxide solution, aqueous solution containing hydrochloric acid and hydrogen peroxide solution, aqueous solution containing sulfuric acid and hydrogen peroxide solution, and highly oxidizing aqueous solution having high oxidation-reduction potential.

11. The method for evaluating an SOI wafer according to Claim 10, wherein the highly oxidizing aqueous solution is electrolyzed anode water.

12. The method for evaluating an SOI wafer according to any one of Claims 6, 10, and 11, wherein when the second cleaning treatment is performed, liquid temperature of the cleaning solution being capable of forming a silicon oxide film is room temperature to 80°c.

13. The method for evaluating an SOI wafer according to any one of Claims 1 to 12, wherein a V_{G}-I_{D} characteristic in a hole side therein is measured by contacting the charge-state stabilizing-treated SOI wafer with the mercury probe and thereby a hole mobility of an SOI layer in the SOI wafer and/or a charge density of a buried oxide film therein are/is evaluated.

14. The method for evaluating an SOI wafer according to Claims 1 to 13, wherein after removing a native oxide film by performing the hydrofluoric acid cleaning treatment, a V_{G}-I_{D} characteristic in an electron side therein is measured by contacting the native oxide film-removed SOI wafer with the mercury probe and thereby an electron mobility of the SOI layer and/or an interface state density between the SOI layer and the buried oxide film are/is evaluated, and then the treatment for stabilizing charge state is performed.

15. The method for evaluating an SOI wafer according to Claim 14, wherein after performing the hydrofluoric acid cleaning treatment, a negative charge is loaded on the SOI layer surface by subjecting the SOI wafer to the corona discharge treatment before measuring the V_{G}-I_{D} characteristic in an electron side therein by contacting the SOI wafer with the mercury probe.
